# EUROPEAN PATENT APPLICATION

(11) **EP 4 024 461 A1**
(43) Date of publication of application: **06.07.2022**
(21) Application number: 20863640.7
(22) Date of filing: 27.02.2020
(51) Int. Cl.: H01L 27/15, H01L 33/00, H01L 33/20, H01L 33/36

(54) **LIGHT EMITTING DEVICE, MANUFACTURING METHOD THEREFOR, AND DISPLAY DEVICE COMPRISING SAME**

(30) Priority: 11.09.2019 KR 20190113149
(71) Applicant: Samsung Display Co., Ltd., Yongin-si, Gyeonggi-do 17113 (KR)
(72) Inventor: CHA, Hyung Rae, Seoul 05236 (KR); KIM, Dong Uk, Hwaseong-si Gyeonggi-do 18505 (KR); KIM, Myeong Hee, Yongin-si Gyeonggi-do 17110 (KR); KIM, Se Young, Gwangju 61951 (KR); CHO, Hyun Min, Seoul 06802 (KR)
(74) Representative: Taor, Simon Edward William
(86) International application number: PCT/KR2020/002802
(87) International publication number: WO 2021/049725

(57) **Abstract**

Provided are a light emitting device, a manufacturing method therefor, and a display device comprising same. The light emitting device comprises: a first semiconductor layer which is doped with a first polarity, and which includes a first part extending in a first direction and a second part connected to one side of the first part; a second semiconductor layer doped with second polarity that differs from the first polarity; an active layer disposed between the first semiconductor layer and the second semiconductor layer; and an insulation film which is disposed to encompass at least the outer surface of the active layer and which extends in the first direction, wherein the diameter of the second part measured in a second direction perpendicular to the first direction is larger than the diameter of the first part measured in the second direction, and the side surface of the second part is inclined.

## Description

### [TECHNICAL FIELD]

The disclosure relates to a light emitting device, a manufacturing method therefor, and a display device comprising same.

### [BACKGROUND ART]

The importance of display devices has steadily increased with the development of multimedia technology. In response thereto, various types of display devices such as an organic light emitting display (OLED), a liquid crystal display (LCD) and the like have been used.

A display device is a device for displaying an image, and includes a display panel, such as an organic light emitting display panel or a liquid crystal display panel. The light emitting display panel may include light emitting elements, e.g., light emitting diodes (LED), and examples of the light emitting diode include an organic light emitting diode (OLED) using an organic material as a fluorescent material and an inorganic light emitting diode using an inorganic material as a fluorescent material.

An inorganic light emitting diode using an inorganic semiconductor as a fluorescent material has an advantage in that it has durability even in a high temperature environment, and has higher efficiency of blue light than an organic light emitting diode. Also, in the manufacturing process, as noted as a drawback of a conventional inorganic light emitting diode, a transfer method using a dielectrophoresis (DEP) method has been developed. Accordingly, continuous studies have been conducted on the inorganic light emitting diode having superior durability and efficiency compared to the organic light emitting diode.

### [DISCLOSURE]

### [Technical Problems]

Aspects of the disclosure provide a light emitting device which is manufactured by etching a semiconductor crystal and whose both ends have different widths and a method of manufacturing the light emitting device.

Aspects of the disclosure also provide a display device which includes the above light emitting device and thus has an increased contact area between the light emitting device and a contact electrode.

It should be noted that aspects of the disclosure are not limited thereto and other aspects, which are not mentioned herein, will be apparent to those of ordinary skill in the art from the following description.

### [Technical Solutions]

According to an embodiment of the disclosure, a light emitting device comprising: a first semiconductor layer doped with a first polarity and comprising a first part extending in a first direction and a second part connected to a side of the first part, a second semiconductor layer doped with a second polarity different from the first polarity, an active layer disposed between the first semiconductor layer and the second semiconductor layer, and an insulating film surrounding an outer surface of at least the active layer and extends in the first direction, wherein a diameter of the second part measured in a second direction perpendicular to the first direction is greater than a diameter of the first part measured in the second direction, and side surfaces of the second part are inclined.

The insulating film may surround an outer surface of the first part of the first semiconductor layer, and the side surfaces of the second part may be exposed without contacting the insulating film.

A length of the second part may be about 10% of a length of the light emitting device.

The second part may comprise an upper surface connected to the first part and a lower surface facing the upper surface, and a diameter of the lower surface of the second part may be greater than a diameter of the upper surface.

The diameter of the lower surface of the second part of the first semiconductor layer may be 1.25 to 1.8 times the diameter of the first part of the first semiconductor layer.

The lower surface of the second part may have a diameter of 750 to 900 nm.

The diameter of the lower surface of the second part may be greater than the sum of the diameter of the first part and a thickness of the insulating film.

At least a part of the upper surface of the second part may contact the insulating film.

An included angle formed by the lower and side surfaces of the second part may be in the range of 65 to 80 degrees.

The light emitting device may further comprise an electrode layer disposed on the second semiconductor layer.

A part of side surfaces of the electrode layer may be exposed without contacting the insulating film.

The insulating film may have a curved outer surface so that the thickness of the insulating film is reduced along the one direction.

According to an embodiment of the disclosure, a method of manufacturing light emitting devices, the method comprising: preparing a substrate and forming a semiconductor structure disposed on the substrate and comprising a first semiconductor, forming a plurality of holes exposing a part of the first semiconductor and semiconductor crystals comprising a part of the first semiconductor and spaced apart from each other by partially etching the semiconductor structure, and forming an insulating film disposed on outer surfaces of the semiconductor crystals and the exposed part of the first semiconductor and separating device rods formed by etching the insulating film and the first semiconductor overlapping the holes from the substrate.

Each of the device rods may comprise a first semiconductor layer comprising a first part extending in a direction and a second part connected to a side of the first part and having a greater diameter than the first part, an active layer disposed on the first part of the first semiconductor layer, and a second semiconductor layer disposed on the active layer.

Each of the semiconductor crystals may comprise the first part of the first semiconductor layer, and in the forming of the device rods, the first semiconductor exposed along the holes may be etched to form the second part of the first semiconductor layer, and the insulating film may be partially removed to expose upper surfaces of the semiconductor crystals.

Each of the device rods may further comprise an electrode layer disposed on the second semiconductor layer.

According to an embodiment of the disclosure, a display device comprising: a substrate, a first electrode disposed on the substrate and a second electrode spaced apart from the first electrode, and at least one light emitting device disposed between the first electrode and the second electrode and electrically connected to the first electrode and the second electrode, wherein the light emitting device may extend in a first direction, and a diameter of one end measured in a second direction perpendicular to the first direction is smaller than a diameter of the other end measured in the second direction.

The light emitting device may comprise a first semiconductor layer comprising a first part extending in the first direction and a second part connected to a side of the first part, an active layer disposed on the first semiconductor layer, a second semiconductor layer disposed on the active layer, an electrode layer disposed on the second semiconductor layer, and an insulating film surrounding an outer surface of at least the active layer and extends in the first direction, wherein a diameter of the second part measured in the second direction may be greater than a diameter of the first part measured in the second direction, and side surfaces of the second part are inclined.

The display device may further comprise a first contact electrode contacting the first electrode and the one end of the light emitting device and a second contact electrode contacting the second electrode and the other end of the light emitting device.

The second contact electrode may contact the second part of the first semiconductor layer and forms a first contact surface in contact with a lower surface of the second part and a second contact surface in contact with a side surface of the second part, and the first contact electrode may contact an upper surface of the electrode layer to form a third contact surface.

The area of the first contact surface may be larger than the area of the third contact surface.

The first contact surface and the second contact surface may be not parallel to each other.

The insulating film of the light emitting device may partially surround side surfaces of the electrode layer, and the first contact electrode may contact the exposed side surfaces of the electrode layer.

Each of the first contact electrode and the second contact electrode may partially contact the insulating film of the light emitting device.

The details of other embodiments are included in the detailed description and the accompanying drawings.

### [Advantageous Effects]

In a light emitting device according to an embodiment, one end may have a greater diameter than the other end, and side surfaces of a semiconductor layer may be partially exposed at the one end. The semiconductor layer of the light emitting device may include a lower surface and inclined side surfaces to form a wide contact surface with a contact electrode of a display device.

Accordingly, the display device including the above light emitting device may reduce contact resistance between the contact electrode and the light emitting device, thereby improving electrical characteristics and luminous efficiency of the light emitting device.

The effects according to the embodiments are not limited by the contents exemplified above, and more various effects are included in this disclosure.

### [BRIEF DESCRIPTION OF DRAWINGS]

FIG. 1 is a schematic plan view of a display device according to an embodiment;
FIG. 2 is a schematic plan view of a pixel of the display device according to the embodiment;
FIG. 3 is a plan view of a subpixel of FIG. 2;
FIG. 4 is a cross-sectional view taken along lines Xa-Xa', Xb-Xb' and Xc-Xc' of FIG. 3;
FIG. 5 is a schematic view of a light emitting device according to an embodiment;
FIG. 6 is a schematic cross-sectional view of the light emitting device according to the embodiment;
FIG. 7 is an enlarged view of a part QL of FIG. 6;
FIG. 8 is an enlarged view of a part QA of FIG. 4;
FIG. 9 is a cross-sectional view of a part of a display device according to an embodiment;
FIG. 10 is a flowchart illustrating a method of manufacturing light emitting devices according to an embodiment;
FIGS. 11 through 16 are cross-sectional views illustrating a process of manufacturing light emitting devices according to an embodiment;
FIGS. 17 through 19 are cross-sectional views illustrating a part of a process of manufacturing a display device according to an embodiment;
FIG. 20 is a cross-sectional view of a part of a display device according to an embodiment;
FIG. 21 is a schematic cross-sectional view of a light emitting device according to an embodiment;
FIG. 22 is a cross-sectional view of a part of a display device including a light emitting device of FIG. 20;
FIGS. 23 and 24 are cross-sectional views of a part of display devices including light emitting devices according to embodiments;
FIG. 25 is a plan view of a subpixel of a display device according to an embodiment; and
FIG. 26 is a plan view of a pixel of a display device according to an embodiment.

### [MODE FOR INVENTION]

The invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

Hereinafter, embodiments will be described with reference to the accompanying drawings.

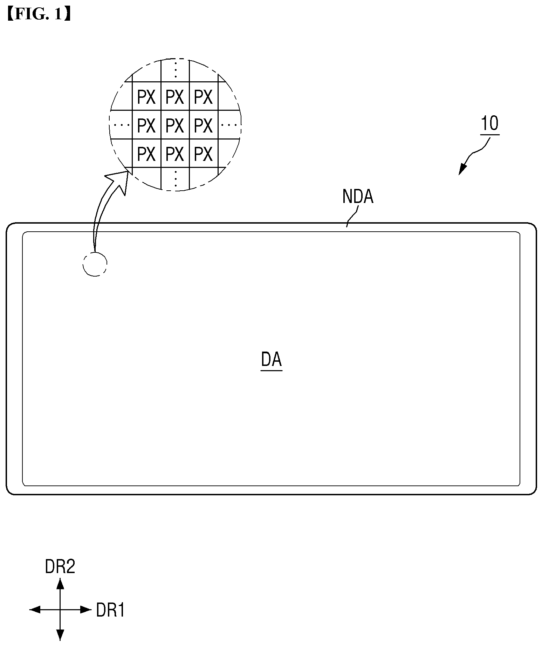

FIG. 1 is a schematic plan view of a display device according to an embodiment.

Referring to FIG. 1, a display device 10 displays moving images or still images. The display device 10 may refer to any electronic device that provides a display screen. Examples of the display device 10 may include televisions, notebook computers, monitors, billboards, the Internet of things (IoT), mobile phones, smartphones, tablet personal computers (PCs), electronic watches, smart watches, watch phones, head mounted displays, mobile communication terminals, electronic notebooks, electronic books, portable multimedia players (PMPs), navigation devices, game machines, digital cameras and camcorders, all of which provide a display screen.

The display device 10 includes a display panel that provides a display screen. Examples of the display panel may include light emitting diode display panels, organic light emitting display panels, quantum dot light emitting display panels, plasma display panels, and field emission display panels. A case where a light emitting diode display panel is applied as an example of the display panel will be described below, but the disclosure is not limited to this case, and other display panels can also be applied as long as the same technical spirit is applicable.

The shape of the display device 10 can be variously modified. For example, the display device 10 may have various shapes such as a horizontally long rectangle, a vertically long rectangle, a square, a quadrangle with rounded corners (vertices), other polygons, and a circle. The shape of a display area DA of the display device 10 may also be similar to the overall shape of the display device 10. In FIG. 1, the display device 10 and the display area DA have a horizontally long rectangular shape.

The display device 10 may include the display area DA and a non-display area NDA. The display area DA may be an area where a screen can be displayed, and the non-display area NDA may be an area where no screen is displayed. The display area DA may also be referred to as an active area, and the non-display area NDA may also be referred to as an inactive area.

The display area DA may generally occupy the center of the display device 10. The display area DA may include a plurality of pixels PX. The pixels PX may be arranged in a matrix direction. Each of the pixels PX may be rectangular or square in plan view. However, the disclosure is not limited thereto, and each of the pixels PX may also have a rhombus shape having each side inclined with respect to a direction. Each of the pixels PX may display a specific color by including one or more light emitting devices 300 which emit light of a specific wavelength band.

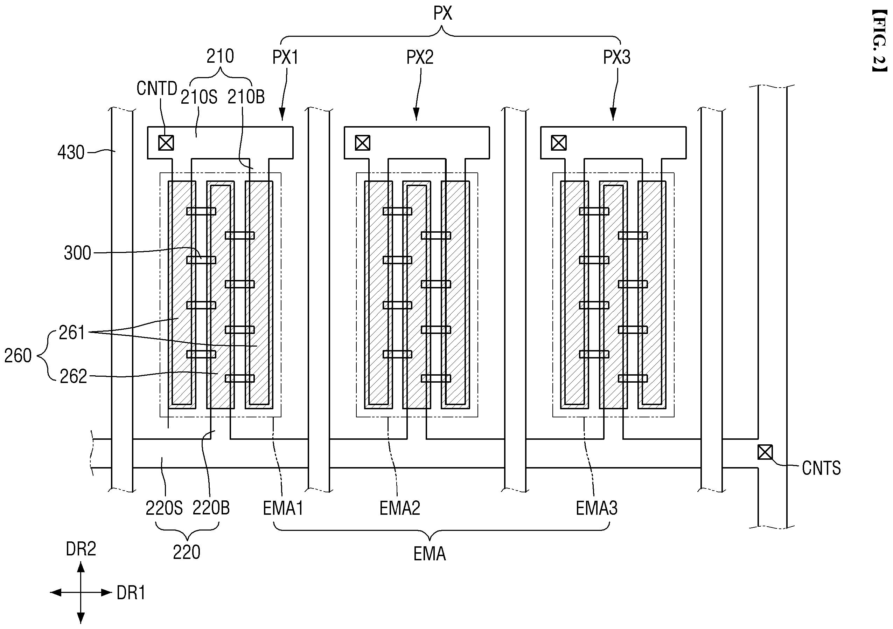

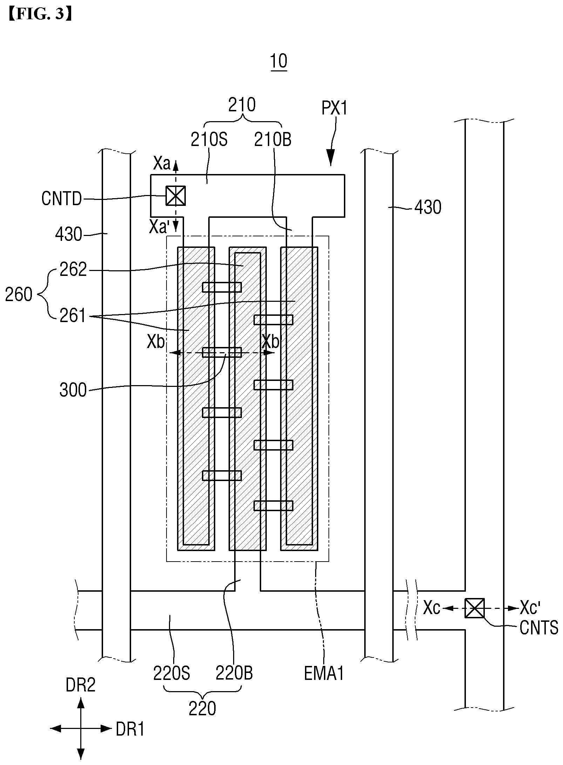

FIG. 2 is a schematic plan view of a pixel of the display device according to the embodiment. FIG. 3 is a plan view of a subpixel of FIG. 2.

Referring to FIGS. 2 and 3, each of the pixels PX may include a first subpixel PX1, a second subpixel PX2, and a third subpixel PX3. The first subpixel PX1 may emit light of a first color, the second subpixel PX2 may emit light of a second color, and the third subpixel PX3 may emit light of a third color. The first color may be blue, the second color may be green, and the third color may be red. However, the disclosure is not limited thereto, and the subpixels PXn may also emit light of the same color. In addition, although a pixel PX includes three subpixels PXn in FIG. 2, the disclosure is not limited thereto, and the pixel PX may also include a larger number of subpixels PXn.

Each subpixel PXn of the display device 10 may include an area defined as an emission area EMA The first subpixel PX1 may include a first emission area EMA1, the second subpixel PX2 may include a second emission area EMA2, and the third subpixel PX3 may include a third emission area EMA3. The emission area EMA may be defined as an area where light emitting devices 300 included in the display device 10 are disposed to emit light of a specific wavelength band. Each of the light emitting devices 300 may include an active layer 330, and the active layer 330 may emit light of a specific wavelength band without directionality. Light emitted from the active layer 330 of each light emitting device 300 may be radiated in a lateral direction of the light emitting device 300 as well as toward both ends of the light emitting device 300. The emission area EMA of each subpixel PXn may include an area in which the light emitting devices 300 are disposed and an area which is adjacent to the light emitting devices 300 and from which light emitted from the light emitting devices 300 is output. In addition, the disclosure is not limited thereto, and the emission area EMA may also include an area from which light emitted from the light emitting devices 300 is output after being reflected or refracted by other members. A plurality of light emitting devices 300 may be disposed in each subpixel PXn, and an area where the light emitting devices 300 are disposed and an area adjacent to this area may form the emission area EMA

Although not illustrated in the drawings, each subpixel PXn of the display device 10 may include a non-emission area defined as an area other than the emission area EMA. The non-emission area may be an area in which the light emitting devices 300 are not disposed and from which no light is output because light emitted from the light emitting devices 300 does not reach this area.

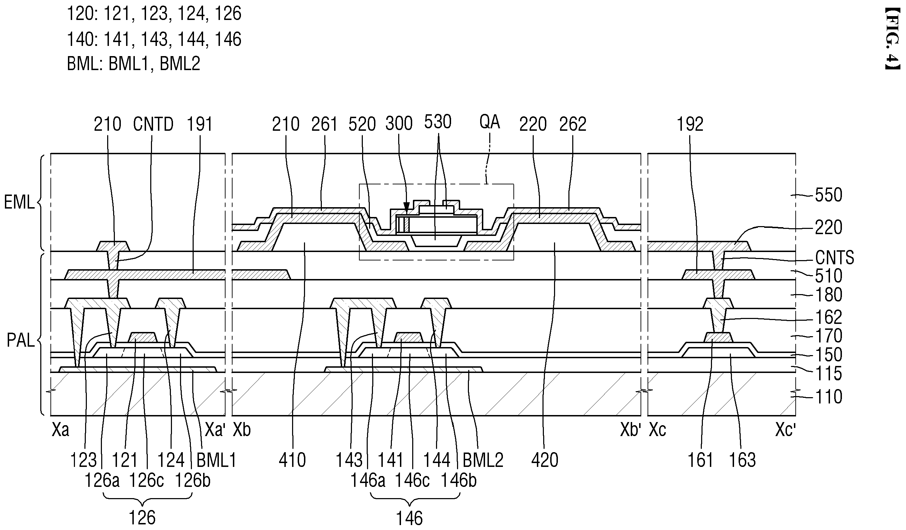

Each subpixel PXn of the display device 10 may include a plurality of electrodes 210 and 220, the light emitting devices 300, a plurality of contact electrodes 260, and a plurality of outer banks 430. In addition, although not illustrated in FIGS. 2 and 3, the display device 10 may further include a plurality of inner banks 410 and 420 (see FIG. 4) and a plurality of insulating layers 510, 520, 530 and 550 (see FIG. 4).

The electrodes 210 and 220 may include a first electrode 210 and a second electrode 220. Each of the first electrode 210 and the second electrode 220 may include an electrode stem part 210S or 220S extending in a first direction DR1 and at least one electrode branch part 210B or 220B extending and branching from the electrode stem part 210S or 220S in a second direction DR2 intersecting the first direction DR1.

The first electrode 210 may include a first electrode stem part 210S extending in the first direction DR1 and at least one first electrode branch part 210B branching from the first electrode stem part 210S and extending in the second direction DR2.

The first electrode stem part 210S of any one pixel may have both ends ending between subpixels PXn and spaced apart from ends of neighboring first electrode stem parts 210S but may lie on substantially the same straight line as the first electrode stem parts 210S of neighboring subpixels (e.g., adjacent in the first direction DR1) in the same row. Since both ends of the first electrode stem parts 210S respectively disposed in the subpixels PXn are spaced apart from each other, a different electrical signal may be transmitted to each first electrode branch part 210B.

The first electrode branch part 210B may branch from at least a part of the first electrode stem part 210S and extend in the second direction DR2 to end at a position spaced apart from a second electrode stem part 220S facing the first electrode stem part 210S.

The second electrode 220 may include the second electrode stem part 220S extending in the first direction DR1 and spaced apart from the first electrode stem part 210S in the second direction DR2 to face the first electrode stem part 210S and a second electrode branch part 220B branching from the second electrode stem part 220S and extending in the second direction DR2. The other end of the second electrode stem part 220S may be connected to the second electrode stem part 220S of another subpixel PXn adjacent in the first direction DR1. That is, unlike the first electrode stem part 210S, the second electrode stem part 220S may extend in the first direction DR1 to cross the subpixels PXn. The second electrode stem part 220S crossing the subpixels PXn may be connected to a peripheral part of the display area DA in which each pixel PX or subpixel PXn is disposed or a part extending in a direction in the non-display area NDA.

The second electrode branch part 220B may be spaced apart from the first electrode branch part 210B to face the first electrode branch part 210B and may end at a position spaced apart from the first electrode stem part 210S. The second electrode branch part 220B may be connected to the second electrode stem part 220S, and an end in the extending direction may be spaced apart from the first electrode stem part 210S in each subpixel PXn.

The first electrode 210 and the second electrode 220 may be electrically connected to a circuit device layer PAL (see FIG. 4) of the display device 10 through contact holes, for example, a first electrode contact hole CNTD and a second electrode contact hole CNTS, respectively. In the drawings, the first electrode contact hole CNTD is formed in the first electrode stem part 210S of each subpixel PXn, and only one second electrode contact hole CNTS is formed in one second electrode stem part 220S crossing the subpixels PXn. However, the disclosure is not limited thereto. In some cases, the second electrode contact hole CNTS may also be formed in each subpixel PXn.

The electrodes 210 and 220 may be electrically connected to the light emitting devices 300 and may receive a predetermined voltage so that the light emitting devices 300 can emit light of a specific wavelength band. In addition, at least a part of each of the electrodes 210 and 220 may be utilized to form an electric field in a subpixel PXn to align the light emitting devices 300.

In an embodiment, the first electrode 210 may be a pixel electrode separate for each subpixel PXn, and the second electrode 220 may be a common electrode commonly connected along each subpixel PXn. Any one of the first electrode 210 and the second electrode 220 may be anodes of the light emitting devices 300, and the other may be cathodes of the light emitting devices 300. However, the disclosure is not limited thereto, and the opposite may also be true.

Although two first electrode branch parts 210B are disposed in each subpixel PXn and one second electrode branch part 220B is disposed between them in the drawings, the disclosure is not limited thereto. In some cases, the first electrode 210 and the second electrode 220 may not include the electrode stem parts 210S and 220S and may extend in the second direction DR2. In addition, the first electrode 210 and the second electrode 220 may not necessarily extend in one direction and may also be disposed in various structures. For example, the first electrode 210 and the second electrode 220 may be partially curved or bent, or any one of the first electrode 210 and the second electrode 220 may surround the other electrode. The structure or shape in which the first electrode 210 and the second electrode 220 are disposed may not be particularly limited as long as the first electrode 210 and the second electrode 220 are at least partially spaced apart to face each other so that a space in which the light emitting devices 300 are to be disposed can be formed between the first electrode 210 and the second electrode 220.

The outer banks 430 may be disposed at boundaries between the subpixels PXn. The outer banks 430 may extend in the second direction DR2 to lie at the boundaries between the subpixels PXn arranged in the first direction DR1. Respective ends of a plurality of first electrode stem parts 210S may be spaced apart from each other by the outer banks 430. However, the disclosure is not limited thereto, and the outer banks 430 may also extend in the first direction DR1 to lie at the boundaries between the subpixels PXn arranged in the second direction DR2. The outer banks 430 may include the same material as the inner banks 410 and 420 to be described later and may be formed at the same time as the inner banks 410 and 420 in one process.

The light emitting devices 300 may be disposed between the first electrode 210 and the second electrode 220. An end of each of the light emitting devices 300 may be electrically connected to the first electrode 210, and the other end may be electrically connected to the second electrode 220. The light emitting devices 300 may be electrically connected to the first electrode 210 and the second electrode 220 respectively through the contact electrodes 260.

The light emitting devices 300 may be spaced apart from each other and may be aligned substantially parallel to each other. A gap between the light emitting devices 300 is not particularly limited. In some cases, a plurality of light emitting devices 300 may be disposed adjacent to each other to form a group and a plurality of other light emitting devices 300 may form a group at a certain distance from the above group, or a plurality of light emitting devices 300 may be oriented and aligned in a direction with non-uniform density. In addition, in an embodiment, the light emitting devices 300 may extend in a direction, and the direction in which each electrode, for example, the first electrode branch part 210B and the second electrode branch part 220B extend and the direction in which the light emitting devices 300 extend may be substantially perpendicular to each other. However, the disclosure is not limited thereto, and the light emitting devices 300 may also extend in a direction not perpendicular but oblique to the direction in which the first electrode branch part 210B and the second electrode branch part 220B extend.

The light emitting devices 300 according to an embodiment may include the active layers 330 including different materials to emit light of different wavelength bands to the outside. The display device 10 according to the embodiment may include the light emitting devices 300 emitting light of different wavelength bands. The light emitting devices 300 of the first subpixel PX1 may include the active layers 330 emitting first light L1 whose central wavelength band is a first wavelength. The light emitting devices 300 of the second subpixel PX2 may include the active layers 330 emitting second light L2 whose central wavelength band is a second wavelength. The light emitting devices 300 of the third subpixel PXn may include the active layers 330 emitting third light L3 whose central wavelength band is a third wavelength.

Accordingly, the first light L1 may be emitted from the first subpixel PX1, the second light L2 may be emitted from the second subpixel PX2, and the third light L3 may be emitted from the third subpixel PX3. In some embodiments, the first light L1 may be blue light whose central wavelength band is in the range of 450 to 495 nm, the second light L2 may be green light whose central wavelength band is in the range of 495 to 570 nm, and the third light L3 may be red light whose central wavelength band is in the range of 620 to 752 nm.

However, the disclosure is not limited thereto. In some cases, the first subpixel PX1, the second subpixel PX2, and the third subpixel PX3 may include the light emitting devices 300 of the same type to emit light of substantially the same color.

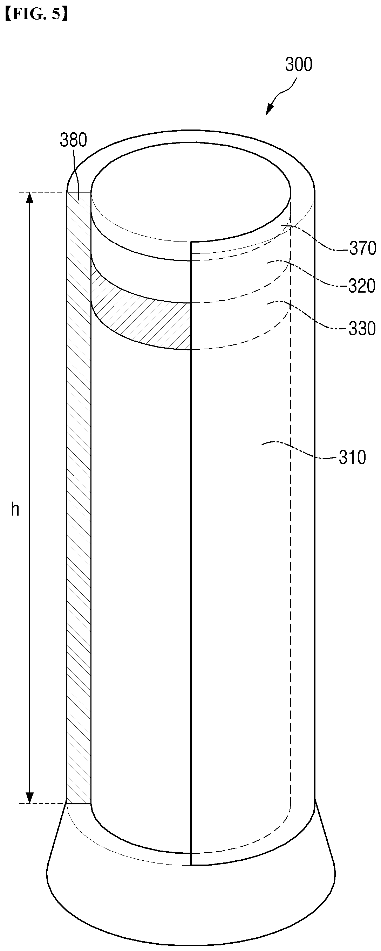

Each of the light emitting devices 300 according to an embodiment may include a semiconductor core and an insulating film 380 (see FIG. 5) surrounding the semiconductor core. The semiconductor core may include a plurality of semiconductor layers 310 and 320 (see FIG. 5) and an active layer 330 (see FIG. 5) disposed between them. An end of each light emitting device 300 may be electrically connected to the first electrode 210, and the other end may be electrically connected to the second electrode 220 to receive an electrical signal. In each light emitting device 300 receiving the electrical signal, light may be generated from the active layer 330 and emitted to the outside.

Here, both ends of each light emitting device 300 are electrically connected to the electrodes 210 and 220 by contacting the contact electrodes 260 to be described later. In order to improve the luminous efficiency of the light emitting devices 300, a smooth contact between the light emitting devices 300 and the contact electrodes 260 may be required. To this end, each of the light emitting devices 300 may further include an electrode layer 370 (see FIG. 5) disposed on at least one surface of the semiconductor layers 310 and 320. However, in a process of manufacturing the light emitting devices 300, a process of etching a semiconductor structure, in which a plurality of layers are stacked, in a direction is performed. In the manufacturing process, a separate process may be further required to form the electrode layer 370 on a lower surface of each light emitting device 300, for example, on a lower surface of a first semiconductor layer 310.

The smooth contact between the light emitting devices 300 and the contact electrodes 260 may be achieved by increasing a contact area between them. To this end, a diameter of one end of each light emitting device 300 according to an embodiment may be greater than that of the other end. The one end of each light emitting device 300 may have a larger contact area with a contact electrode 260 of the display device 10 even if the electrode layer 370 is not disposed, and electrical characteristics of the light emitting devices 300 may be improved, thereby improving the luminous efficiency. This will be described in detail later with reference to other drawings.

At least a part of each of the contact electrodes 260 may extend in a direction. The contact electrodes 260 may contact the light emitting devices 300 and the electrodes 210 and 220, and the light emitting devices 300 may receive an electrical signal from the first electrode 210 and the second electrode 220 through the contact electrodes 260.

The contact electrodes 260 may include a first contact electrode 261 and a second contact electrode 262. The first contact electrode 261 and the second contact electrode 262 may be disposed on the first electrode branch part 210B and the second electrode branch part 220B, respectively.

The first contact electrode 261 may be disposed on the first electrode 210 or the first electrode branch part 210B to extend in the second direction DR2 and may contact the one end of each of the light emitting devices 300. The second contact electrode 262 may be spaced apart from the first contact electrode 261 in the first direction DR1. The second contact electrode 262 may be disposed on the second electrode 220 or the second electrode branch part 220B to extend in the second direction DR2 and may contact the other end of each of the light emitting devices 300. The first contact electrode 261 and the second contact electrode 262 may contact the first electrode 210 and the second electrode 220 exposed through openings of a second insulating layer 520. The light emitting devices 300 may be electrically connected to the first electrode 210 and the second electrode 220 through the first contact electrode 261 and the second contact electrode 262.

In some embodiments, widths of the first contact electrode 261 and the second contact electrode 262 measured in a direction may respectively be greater than widths of the first electrode 210 and the second electrode 220 or widths of the first electrode branch part 210B and the second electrode branch part 220B measured in the direction. Each of the first contact electrode 261 and the second contact electrode 262 may cover sides of the first electrode 210 or the second electrode 220 or sides of the first electrode branch part 210B or the second electrode branch part 220B. However, the disclosure is not limited thereto. In some cases, each of the first contact electrode 261 and the second contact electrode 262 may cover only one side of the first electrode branch part 210B or the second electrode branch part 220B.

Although two first contact electrodes 261 and one second contact electrode 262 are disposed in one subpixel PXn in the drawings, the disclosure is not limited thereto. The number of first contact electrodes 261 and second contact electrodes 262 may vary according to the number of first electrodes 210 and second electrodes 220 or the number of first electrode branch parts 210B and second electrode branch parts 220B disposed in each subpixel PXn.

Although not illustrated in FIGS. 2 and 3, the display device 10 may include the circuit device layer PAL located under each of the electrodes 210 and 220 and a plurality of insulating layers disposed on the circuit device layer PAL. The stacked structure of the display device 10 will now be described in detail with reference to FIG. 4.

FIG. 4 is a cross-sectional view taken along lines Xa-Xa', Xb-Xb' and Xc-Xc' of FIG. 3.

FIG. 4 illustrates a cross section of only the first subpixel PX1, but the same illustration may be applied to other pixels PX or subpixels PXn. FIG. 4 illustrates a cross section across an end and the other end of a light emitting device 300 disposed in the first subpixel PX1.

Referring to FIG. 4 in conjunction with FIGS. 2 and 3, the display device 10 may include the circuit device layer PAL and a light emitting layer EML The circuit device layer PAL may include a substrate 110, a buffer layer 115, light blocking layers BML, conductive wirings 191 and 192, first and second transistors 120 and 140, etc. The light emitting layer EML may include the above-described electrodes 210 and 220, the light emitting devices 300, the contact electrodes 261 and 262, the insulating layers 510, 520, 530 and 550, etc.

Specifically, the substrate 110 may be an insulating substrate. The substrate 110 may be made of an insulating material such as glass, quartz, or polymer resin. In addition, the substrate 110 may be a rigid substrate, but may also be a flexible substrate that can be bent, folded, rolled, etc.

The light blocking layers BML may be disposed on the substrate 110. The light blocking layers BML may include a first light blocking layer BML1 and a second light blocking layer BML2. The first light blocking layer BML1 may be electrically connected to a first source electrode 123 of the first transistor 120 which will be described later. The second light blocking layer BML2 may be electrically connected to a second source electrode 143 of the second transistor 140.

The first light blocking layer BML1 and the second light blocking layer BML2 are overlapped by a first active material layer 126 of the first transistor 120 and a second active material layer 146 of the second transistor 140, respectively. The first and second light blocking layers BML1 and BML2 may include a light blocking material to prevent light from entering the first and second active material layers 126 and 146. For example, the first and second light blocking layers BML1 and BML2 may be made of an opaque metal material that blocks transmission of light. However, the disclosure is not limited thereto. In some cases, the light blocking layers BML may be omitted.

The buffer layer 115 is disposed on the light blocking layers BML and the substrate 110. The buffer layer 115 may entirely cover the substrate 110 as well as the light blocking layers BML. The buffer layer 115 may prevent diffusion of impurity ions, prevent penetration of moisture or outside air, and perform a surface planarization function. In addition, the buffer layer 115 may insulate the light blocking layers BML and the first and second active material layers 126 and 146 from each other.

A semiconductor layer is disposed on the buffer layer 115. The semiconductor layer may include the first active material layer 126 of the first transistor 120, the second active material layer 146 of the second transistor 140, and an auxiliary layer 163. The semiconductor layer may include polycrystalline silicon, monocrystalline silicon, an oxide semiconductor, or the like.

The first active material layer 126 may include a first doped region 126a, a second doped region 126b, and a first channel region 126c. The first channel region 126c may be disposed between the first doped region 126a and the second doped region 126b. The second active material layer 146 may include a third doped region 146a, a fourth doped region 146b, and a second channel region 146c. The second channel region 146c may be disposed between the third doped region 146a and the fourth doped region 146b. The first active material layer 126 and the second active material layer 146 may include polycrystalline silicon. The polycrystalline silicon may be formed by crystalizing amorphous silicon. Examples of the crystallization method may include, but are not limited to, a rapid thermal annealing (RTA) method, a solid phase crystallization (SPC) method, an excimer laser annealing (ELA) method, a metal induced crystallization (MILC) method, and a sequential lateral solidification (SLS) method. Alternatively, the first active material layer 126 and the second active material layer 146 may include monocrystalline silicon, low-temperature polycrystalline silicon, amorphous silicon, or the like. The first doped region 126a, the second doped region 126b, the third doped region 146a, and the fourth doped region 146b may be, but are not limited to, regions of the first active material layer 126 and the second active material layer 146 which are doped with impurities.

However, the first active material layer 126 and the second active material layer 146 are not necessarily limited to the above description. In an embodiment, the first active material layer 126 and the second active material layer 146 may include an oxide semiconductor. In this case, the first doped region 126a and the third doped region 146a may be first conducting regions, and the second doped region 126b and the fourth doped region 146b may be second conducting regions. When the first active material layer 126 and the second active material layer 146 include an oxide semiconductor, the oxide semiconductor may be an oxide semiconductor containing indium (In). In some embodiments, the oxide semiconductor may be, but is not limited to, indium tin oxide (ITO), indium zinc oxide (IZO), indium gallium oxide (IGO), indium zinc tin oxide (IZTO), indium gallium tin oxide (IGTO), or indium gallium zinc tin oxide (IGZTO).

A first gate insulating layer 150 is disposed on the semiconductor layer. The first gate insulating layer 150 may entirely cover the buffer layer 115 as well as the semiconductor layer. The first gate insulating layer 150 may function as a gate insulating layer of each of the first and second transistors 120 and 140.

A first conductive layer is disposed on the first gate insulating layer 150. The first conductive layer disposed on the first gate insulating layer 150 may include a first gate electrode 121 disposed on the first active material layer 126 of the first transistor 120, a second gate electrode 141 disposed on the second active material layer 146 of the second transistor 140, and a wiring pattern 161 disposed on the auxiliary layer 163. The first gate electrode 121 may overlap the first channel region 126c of the first active material layer 126, and the second gate electrode 141 may overlap the second channel region 146c of the second active material layer 146.

An interlayer insulating film 170 is disposed on the first conductive layer. The interlayer insulating film 170 may function as an insulating film between the first conductive layer and other layers disposed on the first conductive layer. In addition, the interlayer insulating film 170 may include an organic insulating material and perform a surface planarization function.

A second conductive layer is disposed on the interlayer insulating film 170. The second conductive layer includes the first source electrode 123 and a first drain electrode 124 of the first transistor 120, the second source electrode 143 and a second drain electrode 144 of the second transistor 140, and a power electrode 162 disposed on the wiring pattern 161.

The first source electrode 123 and the first drain electrode 124 may respectively contact the first doped region 126a and the second doped region 126b of the first active material layer 126 through contact holes penetrating the interlayer insulating film 170 and the first gate insulating layer 150. The second source electrode 143 and the second drain electrode 144 may respectively contact the third doped region 146a and the fourth doped region 146b of the second active material layer 146 through contact holes penetrating the interlayer insulating film 170 and the first gate insulating layer 150. In addition, the first source electrode 123 and the second source electrode 143 may be electrically connected to the first light blocking layer BML1 and the second light blocking layer BML2 through other contact holes, respectively.

A protective layer 180 may be disposed on the second conductive layer. The protective layer 180 may cover the second conductive layer and may be entirely disposed on the interlayer insulating film 170. That is, the protective layer 180 may cover the first source electrode 123, the first drain electrode 124, the second source electrode 143, and the second drain electrode 144.

A conductive wiring layer may be disposed on the protective layer 180. The conductive wiring layer may include a first conductive wiring 191 and a second conductive wiring 192. The first conductive wiring 191 and the second conductive wiring 192 may be electrically connected to the first source electrode 123 of the first transistor 120 and the power electrode 162, respectively. The conductive wiring layer may also be electrically connected to the first electrode 210 and the second electrode 220 of the light emitting layer EML and may transmit an electrical signal received from the first transistor 120 and the power electrode 162 to each of the electrodes 210 and 220.

A first insulating layer 510 is disposed on the conductive wiring layer. The first insulating layer 510 may include an organic insulating material and perform a surface planarization function.

The inner banks 410 and 420, the outer banks 430 (see FIG. 4), the electrodes 210 and 220, and the light emitting devices 300 may be disposed on the first insulating layer 510.

As described above, the outer banks 430 may extend in the first direction DR1 or the second direction DR2 to lie at the boundaries of the subpixels PXn. That is, the outer banks 430 may define the boundary of each subpixel PXn.

Although not illustrated in the drawings, when ink in which the light emitting devices 300 are dispersed is sprayed using an inkjet printing device during the manufacture of the display device 10, the outer banks 430 may prevent the ink from flowing over the boundary of each subpixel PXn. The outer banks 430 may separate inks in which different light emitting devices 300 are dispersed for different subpixels PXn, so that the inks are not mixed with each other. However, the disclosure is not limited thereto.

The inner banks 410 and 420 may be spaced apart from each other in each subpixel PXn. The inner banks 410 and 420 may include a first inner bank 410 and a second inner bank 420 disposed adjacent to the center of each subpixel PXn.

The first inner bank 410 and the second inner bank 420 are spaced apart to face each other. The first electrode 210 may be disposed on the first inner bank 410, and the second electrode 220 may be disposed on the second inner bank 420. It may be understood from FIGS. 3 and 4 that the first electrode branch part 210B is disposed on the first inner bank 410 and the second electrode branch part 220B is disposed on the second inner bank 420.

Like the first electrode 210 and the second electrode 220, the first inner bank 410 and the second inner bank 420 may extend in the second direction DR2 in each subpixel PXn. Although not illustrated in the drawings, the first inner bank 410 and the second inner bank 420 may extend in the second direction DR2 toward a subpixel PXn neighboring in the second direction DR2. However, the disclosure is not limited thereto, and the first inner bank 410 and the second inner bank 420 may also be disposed in each subpixel PXn to form patterns in the entire display device 10.

At least a part of each of the first inner bank 410 and the second inner bank 420 may protrude from the first insulating layer 510. Each of the first inner bank 410 and the second inner bank 420 may protrude upward from a plane in which the light emitting devices 300 are disposed, and the protruding part may be at least partially inclined. The protruding shape of each of the first inner bank 410 and the second inner bank 420 is not particularly limited. Since the inner banks 410 and 420 protruding from the first insulating layer 510 have inclined side surfaces, light emitted from the light emitting devices 300 may be reflected by the inclined side surfaces of the inner banks 410 and 420. As will be described later, when the electrodes 210 and 220 disposed on the inner banks 410 and 420 include a material having high reflectivity, light emitted from the light emitting devices 300 may be reflected by the electrodes 210 and 220 located on the inclined side surfaces of the inner banks 410 and 420 to travel upward above the first insulating layer 510.

In other words, while the outer banks 430 separate neighboring subpixels PXn and prevent ink from overflowing to adjacent subpixels PXn in an inkjet process, the inner banks 410 and 420 have a protruding structure in each subpixel PXn to function as reflective barriers that reflect light emitted from the light emitting devices 300 upward above the first insulating layer 510. However, the disclosure is not limited thereto. The inner banks 410 and 420 and the outer banks 430 may include, but are not limited to, polyimide (PI).

The electrodes 210 and 220 may be disposed on the first insulating layer 510 and the inner banks 410 and 420. As described above, each of the electrodes 210 and 220 includes the electrode stem part 210S or 220S and the electrode branch part 210B or 220B. The line Xa-Xa' of FIG. 3 is a line crossing the first electrode stem part 210S, the line Xb-Xb' of FIG. 3 is a line crossing the first electrode branch part 210B and the second electrode branch part 220B, and the line Xc-Xc' of FIG. 3 is a line crossing the second electrode stem part 220S. That is, it may be understood that the first electrode 210 disposed in the area Xa-Xa' of FIG. 4 is the first electrode stem part 210S, the first electrode 210 and the second electrode 220 disposed in the area Xb-Xb' of FIG. 4 are the first electrode branch part 210B and the second electrode branch part 220B, respectively, and the second electrode 220 disposed in the area Xc-Xc' of FIG. 4 is the second electrode stem part 220S. The electrode stem parts 210S and 220S and the electrode branch parts 210B and 220B may form the first electrode 210 and the second electrode 220, respectively.

Each of the first electrode 210 and the second electrode 220 may have a part disposed on the first insulating layer 510 and a part disposed on the first inner bank 410 or the second inner bank 420. That is, the widths of the first electrode 210 and the second electrode 220 may be greater than those of the inner banks 410 and 420. A part of a lower surface of each of the first electrode 210 and the second electrode 220 may contact the first insulating layer 510, and the other part may contact the inner bank 410 or 420.

Although not illustrated in the drawings, the first electrode stem part 210S and the second electrode stem part 220S of the first electrode 210 and the second electrode 220 which extend in the first direction DR1 may partially overlap the first inner bank 410 and the second inner bank 420. However, the disclosure is not limited thereto, and the first electrode stem part 210S and the second electrode stem part 220S may also not overlap the first inner bank 410 and the second inner bank 420.

The first electrode contact hole CNDT penetrating the first insulating layer 510 to expose a part of the first conductive wiring 191 may be formed in the first electrode stem part 210S of the first electrode 210. The first electrode 210 may contact the first conductive wiring 191 through the first electrode contact hole CNTD. The first electrode 210 may be electrically connected to the first source electrode 123 of the first transistor 120 to receive an electrical signal.

The second electrode contact hole CNTS penetrating the first insulating layer 510 to expose a part of the second conductive wiring 192 may be formed in the second electrode stem part 220S of the second electrode 220. The second electrode 220 may contact the second conductive wiring 192 through the second electrode contact hole CNTS. The second electrode 220 may be electrically connected to the power electrode 162 to receive an electrical signal.

Parts of the first electrode 210 and the second electrode 220, for example, the first electrode branch part 210B and the second electrode branch part 220B may cover the first inner bank 410 and the second inner bank 420, respectively. The first inner bank 410 and the second inner bank 420 may be spaced apart to face each other, and a plurality of light emitting devices 300 may be disposed between them.

Each of the electrodes 210 and 220 may include a transparent conductive material. For example, each of the electrodes 210 and 220 may include a material such as indium tin oxide (ITO), indium zinc oxide (IZO), or indium tin zinc oxide (ITZO). However, the disclosure is not limited thereto. In some embodiments, each of the electrodes 210 and 220 may include a conductive material having high reflectivity. For example, each of the electrodes 210 and 220 may include a metal such as silver (Ag), copper (Cu) or aluminum (Al) as a material having high reflectivity. In this case, each of the electrodes 210 and 220 may reflect incident light in an upward direction of each subpixel PXn.

In addition, each of the electrodes 210 and 220 may have a structure in which a transparent conductive material and a metal layer having high reflectivity are each stacked in one or more layers or may be formed as a single layer including them. In an embodiment, each of the electrodes 210 and 220 may have a stacked structure of ITO/Ag/ITO/IZO or may be an alloy containing aluminum (Al), nickel (Ni), lanthanum (La), etc. However, the disclosure is not limited thereto.

The second insulating layer 520 is disposed on the first insulating layer 510, the first electrode 210, and the second electrode 220. The second insulating layer 520 partially covers the first electrode 210 and the second electrode 220. The second insulating layer 520 may cover most of upper surfaces of the first electrode 210 and the second electrode 220 but may include openings (not illustrated) partially exposing the first electrode 210 and the second electrode 220. The openings of the second insulating layer 520 may be positioned to expose the relatively flat upper surfaces of the first electrode 210 and the second electrode 220.

In an embodiment, the second insulating layer 520 may be stepped such that a part of an upper surface of the second insulating layer 520 is depressed between the first electrode 210 and the second electrode 220. In some embodiments, the second insulating layer 520 may include an inorganic insulating material, and a part of the upper surface of the second insulating layer 520 disposed to cover the first electrode 210 and the second electrode 220 may be depressed due to a step formed by the electrodes 210 and 220 disposed under the second insulating layer 520. The light emitting devices 300 disposed on the second insulating layer 520 between the first electrode 210 and the second electrode 220 may form an empty space with the depressed upper surface of the second insulating layer 520. The light emitting devices 300 may be partially spaced apart from the upper surface of the second insulating layer 520, and the empty space may be filled with a material that forms a third insulating layer 530 to be described later.

However, the disclosure is not limited thereto. The second insulating layer 520 may also form a flat upper surface so that the light emitting devices 300 can be disposed on the flat upper surface. The upper surface may extend in a direction toward the first electrode 210 and the second electrode 220 and may end on inclined side surfaces of the first electrode 210 and the second electrode 220. That is, the second insulating layer 520 may be disposed in areas where the electrodes 210 and 220 overlap the inclined side surfaces of the first inner bank 410 and the second inner bank 420, respectively. The contact electrodes 260 to be described later may contact exposed areas of the first electrode 210 and the second electrode 220 and may smoothly contact ends of the light emitting devices 300 on the flat upper surface of the second insulating layer 520.

The second insulating layer 520 may protect the first electrode 210 and the second electrode 220 while insulating them from each other. In addition, the second insulating layer 520 may prevent the light emitting devices 300 disposed on the second insulating layer 520 from directly contacting other members and thus being damaged. However, the shape and structure of the second insulating layer 520 are not limited thereto.

The light emitting devices 300 may be disposed on the second insulating layer 520 between the electrodes 210 and 220. For example, at least one light emitting device 300 may be disposed on the second insulating layer 520 disposed between the electrode branch parts 210B and 220B. However, the disclosure is not limited thereto. Although not illustrated in the drawings, at least some of the light emitting devices 300 disposed in each subpixel PXn may be disposed in an area other than the area between the electrode branch parts 210B and 220B. In addition, a part of each light emitting device 300 may overlap the electrodes 210 and 220. The light emitting devices 300 may be disposed on respective ends of the first electrode branch part 210B and the second electrode branch part 220B which face each other.

In each of the light emitting devices 300, a plurality of layers may be disposed in a direction horizontal to the first insulating layer 510. Each of the light emitting devices 300 of the display device 10 according to the embodiment may extend in one direction and may have a structure in which a plurality of semiconductor layers are sequentially disposed in the one direction. In each of the light emitting devices 300, the first semiconductor layer 310, the active layer 330, a second semiconductor layer 320 and the electrode layer 370 may be sequentially disposed along the one direction, and the insulating film 380 may surround outer surfaces of the above layers. The direction in which the light emitting devices 300 disposed in the display device 10 extend may be parallel to the first insulating layer 510, and the semiconductor layers included in each of the light emitting devices 300 may be sequentially disposed along a direction parallel to an upper surface of the first insulating layer 510. However, the disclosure is not limited thereto. In some cases, when the light emitting devices 300 have a different structure, the layers may be disposed in a direction perpendicular to the first insulating layer 510.

In addition, an end of each of the light emitting devices 300 may contact the first contact electrode 261, and the other end may contact the second contact electrode 262. According to an embodiment, the insulating film 380 may not be formed on end surfaces of each light emitting device 300 in the extending direction of the light emitting device 300, thereby exposing the end surfaces. Thus, the exposed areas of each of the light emitting devices 300 may contact the first contact electrode 261 and the second contact electrode 262 to be described later. However, the disclosure is not limited thereto. In some cases, at least a part of the insulating film 380 of each light emitting device 300 may be removed, and the insulating film 380 may be removed to partially expose side surfaces of both ends of the light emitting device 300. During a process of manufacturing the display device 10, the insulating film 380 may be partially removed in an operation of forming the third insulating layer 530 covering an outer surface of each light emitting device 300. The exposed side surfaces of each light emitting device 300 may contact the first contact electrode 261 and the second contact electrode 262. However, the disclosure is not limited thereto.

The third insulating layer 530 may be disposed on a part of each light emitting device 300 disposed between the first electrode 210 and the second electrode 220. The third insulating layer 530 may partially cover the outer surfaces of the light emitting devices 300. Thus, the third insulating layer 530 may protect the light emitting devices 300 while fixing the light emitting devices 300 in the process of manufacturing the display device 10. According to an embodiment, the third insulating layer 530 may be disposed on the light emitting devices 300 but may expose an end and the other end of each of the light emitting devices 300. The exposed ends of each of the light emitting devices 300 may contact the contact electrodes 260, and the light emitting devices 300 may receive an electrical signal from each of the electrodes 210 and 220. This shape of the third insulating layer 530 may be formed by performing a patterning process on a material that forms the third insulating layer 530 using a conventional mask process. A mask used to form the third insulating layer 530 may have a width smaller than a length of each light emitting device 300, and the material that forms the third insulating layer 530 may be patterned to expose both ends of each of the light emitting devices 300. However, the disclosure is not limited thereto.

In addition, in an embodiment, a part of the material of the third insulating layer 530 may be disposed between the lower surfaces of the light emitting devices 300 and the second insulating layer 510. The third insulating layer 530 may also be formed to fill the space between the second insulating layer 520 and each light emitting device 300 formed during the process of manufacturing the display device 10. Accordingly, the third insulating layer 530 may be formed to cover the outer surface of each light emitting device 300. However, the disclosure is not limited thereto.

The third insulating layer 530 may extend in the second direction DR2 between the first electrode branch part 210B and the second electrode branch part 220B in plan view. For example, the third insulating layer 530 disposed on the first insulating layer 510 may have an island or linear shape in plan view.

Each of the first contact electrode 261 and the second contact electrode 262 is disposed on the electrode 210 or 220 and the third insulating layer 530. The third insulating layer 530 may be disposed between the first contact electrode 261 and the second contact electrode 262, and the third insulating layer 530 may insulate the first contact electrode 261 and the second contact electrode 262 from each other to prevent them from directly contacting each other.

As described above, the first contact electrode 261 and the second contact electrode 262 may contact at least one end of each light emitting device 300 and may each be electrically connected to the first electrode 210 or the second electrode 220 to receive an electrical signal.

The first contact electrode 261 may contact an exposed area of the first electrode 210 on the first inner bank 410, and the second contact electrode 262 may contact an exposed area of the second electrode 220 on the second inner bank 420. The first contact electrode 261 and the second contact electrode 262 may send an electrical signal received from each electrode 210 or 220 to the light emitting devices 300.

The contact electrodes 260 may include a conductive material such as ITO, IZO, ITZO, or aluminum (Al). However, the disclosure is not limited thereto.

A passivation layer 550 may be disposed on the contact electrodes 260 and the third insulating layer 530. The passivation layer 550 may function to protect the members disposed on the first insulating layer 510 from the external environment.

Each of the first insulating layer 510, the second insulating layer 520, the third insulating layer 530, and the passivation layer 550 described above may include an inorganic insulating material or an organic insulating material. In an embodiment, the first insulating layer 510, the second insulating layer 520, the third insulating layer 530, and the passivation layer 550 may include an inorganic insulating material such as silicon oxide (SiOx), silicon nitride (SiNx), silicon oxynitride (SiOxNy), aluminum oxide (Al2O3), or aluminum nitride (AlN). Alternatively, the first insulating layer 510, the second insulating layer 520, the third insulating layer 530, and the passivation layer 550 may include an organic insulating material such as acrylic resin, epoxy resin, phenolic resin, polyamide resin, polyimide resin, unsaturated polyester resin, polyphenylene resin, polyphenylene sulfide resin, benzocyclobutene, cardo resin, siloxane resin, silsesquioxane resin, polymethyl methacrylate, polycarbonate, or polymethyl methacrylate-polycarbonate synthetic resin. However, the disclosure is not limited thereto.

The display device 10 according to the embodiment may include the light emitting devices 300, each including the electrode layer 370 and the insulating film 380 having more than a certain thickness. In each of the light emitting devices 300 according to an embodiment, the active layer 330 may be prevented from being damaged, or the electrode layer 370 may be prevented from being removed during the process of manufacturing the light emitting device 300 and the process of manufacturing the display device 10. In addition, the luminous efficiency and luminous reliability of the light emitting devices 300 can be improved. The light emitting devices 300 according to the embodiment will now be described in detail with reference to other drawings.

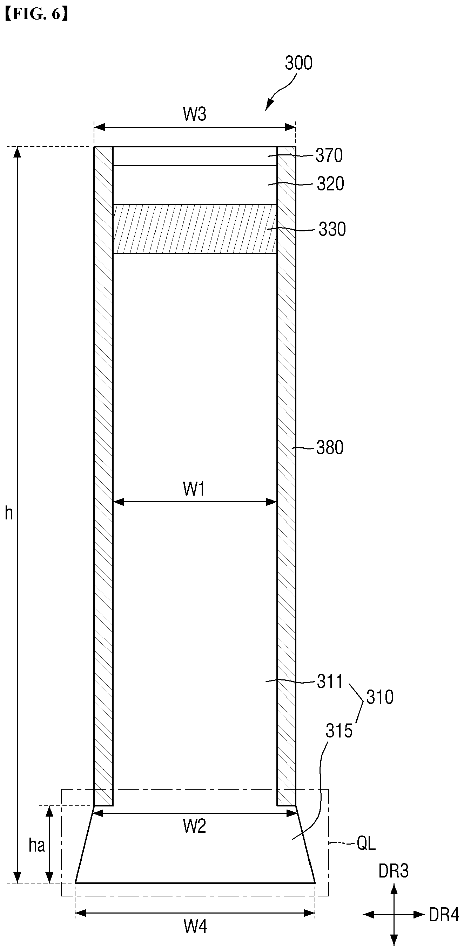

FIG. 5 is a schematic view of a light emitting device according to an embodiment. FIG. 6 is a schematic cross-sectional view of the light emitting device according to the embodiment.

A light emitting device 300 may be a light emitting diode. Specifically, the light emitting device 300 may be an inorganic light emitting diode having a size of micrometers or nanometers and made of an inorganic material. When an electric field is formed in a specific direction between two electrodes facing each other, the inorganic light emitting diode may be aligned between the two electrodes in which polarities are formed. The light emitting device 300 may be aligned between two electrodes by an electric field formed on the electrodes.

The light emitting device 300 according to the embodiment may extend in one direction. The light emitting device 300 may be shaped like a rod, a wire, a tube, or the like. In an embodiment, the light emitting device 300 may be shaped like a cylinder or a rod. However, the shape of the light emitting device 300 is not limited thereto, and the light emitting device 300 may also have various shapes including polygonal prisms, such as a cube, a rectangular parallelepiped and a hexagonal prism, and a shape extending in a direction and having a partially inclined outer surface. A plurality of semiconductors included in the light emitting device 300 which will be described later may be sequentially disposed or stacked along the one direction.

The light emitting device 300 may include a semiconductor layer doped with impurities of any conductivity type (e.g., a p type or an n type). The semiconductor layer may receive an electrical signal from an external power source and emit light in a specific wavelength band.

The light emitting device 300 according to the embodiment may emit light in a specific wavelength band. In an embodiment, an active layer 330 may emit blue light whose central wavelength band is in the range of 450 to 495 nm. However, the central wavelength band of the blue light is not limited to the above range and should be understood to include all wavelength ranges that can be recognized as blue in the art to which the disclosure pertains. In addition, light emitted from the active layer 330 of the light emitting device 300 is not limited to the blue light and may also be green light whose central wavelength band is in the range of 495 to 570 nm or red light whose central wavelength band is in the range of 620 to 750 nm. The light emitting device 300 emitting the blue light will be described below as an example.

Referring to FIGS. 5 and 6, the light emitting device 300 may include a semiconductor core and an insulating film 380 surrounding the semiconductor core. The semiconductor core of the light emitting device 300 may include a first semiconductor layer 310, a second semiconductor layer 320, and the active layer 330. In addition, the light emitting device 300 according to the embodiment may further include an electrode layer 370 disposed on a surface of the first semiconductor layer 310 or the second semiconductor layer 320.

The first semiconductor layer 310 may be an n-type semiconductor. In an example, when the light emitting device 300 emits light in a blue wavelength band, the first semiconductor layer 310 may include a semiconductor material having a chemical formula of AlxGayIn1-x-yN (0≤x≤1, 0≤y≤1, 0≤x+y≤1), for example, any one or more of n-type doped AlGaInN, GaN, AlGaN, InGaN, AlN, and InN. The first semiconductor layer 310 may be doped with an n-type dopant, and the n-type dopant may be, for example, Si, Ge, or Sn. In an embodiment, the first semiconductor layer 310 may be n-GaN doped with n-type Si. A length of the first semiconductor layer 310 may be in the range of, but not limited to, 1.5 to 5 *µ*m*.*

The first semiconductor layer 310 according to an embodiment may include a first part 311 and a second part 315. The first semiconductor layer 310 may include the first part 311 extending in a direction and the second part 315 formed on a surface of the first part 311 and having a greater diameter than the first part 311. The first part 311 and the second part 315 are referred to as such to define a part of the first semiconductor layer 310. They are not formed as separate layers but are integrally formed to form one first semiconductor layer 310. As described above, both ends of the light emitting device 300 may have different diameters, and an area in contact with the contact electrode 261 or 262 of the display device 10 may be larger at an end having a greater diameter. The light emitting device 300 may include the second part 315 formed on a surface of the first semiconductor layer 310, and the second part 315 may have a greater diameter than the first part 311 and other semiconductor layers or the active layer 330. This will be described in more detail later with reference to other drawings.

The second semiconductor layer 320 is disposed on the active layer 330 to be described later. The second semiconductor layer 320 may be a p-type semiconductor. In an example, when the light emitting device 300 emits light in a blue or green wavelength band, the second semiconductor layer 320 may include a semiconductor material having a chemical formula of AlxGayIn1-x-yN (0≤x≤1, 0≤y≤1, 0≤x+y≤1), for example, any one or more of p-type doped AlGaInN, GaN, AlGaN, InGaN, AlN, and InN. The second semiconductor layer 320 may be doped with a p-type dopant, and the p-type dopant may be, for example, Mg, Zn, Ca, Se, or Ba. In an embodiment, the second semiconductor layer 320 may be p-GaN doped with p-type Mg. A length of the second semiconductor layer 320 may be in the range of, but not limited to, 0.05 to 0.10 *µ*m*.*

Although each of the first semiconductor layer 310 and the second semiconductor layer 320 is composed of one layer in the drawings, the disclosure is not limited thereto. According to some embodiments, each of the first semiconductor layer 310 and the second semiconductor layer 320 may include more layers, for example, may further include a clad layer or a tensile strain barrier reducing (TSBR) layer depending on the material of the active layer 330. This will be described later with reference to other drawings.

The active layer 330 is disposed between the first semiconductor layer 310 and the second semiconductor layer 320. The active layer 330 may include a material having a single or multiple quantum well structure. When the active layer 330 includes a material having a multiple quantum well structure, it may have a structure in which a plurality of quantum layers and a plurality of well layers are alternately stacked. The active layer 330 may emit light through combination of electron-hole pairs according to an electrical signal received through the first semiconductor layer 310 and the second semiconductor layer 320. For example, when the active layer 330 emits light in the blue wavelength band, it may include a material such as AlGaN or AlGaInN. In particular, when the active layer 330 has a multiple quantum well structure in which a quantum layer and a well layer are alternately stacked, the quantum layer may include a material such as AlGaN or AlGaInN, and the well layer may include a material such as GaN or AllnN. In an embodiment, the active layer 330 may include AlGaInN as a quantum layer and AIInN as a well layer to emit blue light whose central wavelength band is in the range of 450 to 495 nm as described above.

However, the disclosure is not limited thereto, and the active layer 330 may also have a structure in which a semiconductor material having a large band gap energy and a semiconductor material having a small band gap energy are alternately stacked or may include different group 3 to 5 semiconductor materials depending on the wavelength band of light that it emits. Light emitted from the active layer 330 is not limited to light in the blue wavelength band. In some cases, the active layer 330 may emit light in a red or green wavelength band. A length of the active layer 330 may be in the range of, but not limited to, 0.05 to 0.10 *µ*m*.*

Light emitted from the active layer 330 may be radiated not only to an outer surface of the light emitting device 300 in a longitudinal direction, but also to both side surfaces. The direction of light emitted from the active layer 330 is not limited to one direction.

The electrode layer 370 may be an ohmic contact electrode. However, the disclosure is not limited thereto, and the electrode layer 370 may also be a Schottky contact electrode. The light emitting device 300 may include at least one electrode layer 370. Although the light emitting device 300 includes one electrode layer 370 in FIG. 6, the disclosure is not limited thereto. In some cases, the light emitting device 300 may include more electrode layers 370, or the electrode layer 370 may be omitted. The following description of the light emitting device 300 may apply equally even if the number of electrode layers 370 is changed or another structure is further included.

When the light emitting device 300 is electrically connected to an electrode or a contact electrode in the display device 10 according to the embodiment, the electrode layer 370 may reduce the resistance between the light emitting device 300 and the electrode or the contact electrode. The electrode layer 370 may include a conductive metal. For example, the electrode layer 370 may include at least any one of aluminum (Al), titanium (Ti), indium (In), gold (Au), silver (Ag), indium tin oxide (ITO), indium zinc oxide (IZO), and indium tin zinc oxide (ITZO). In addition, the electrode layer 370 may include an n-type or p-type doped semiconductor material. The electrode layer 370 may include the same material or different materials. A length of the electrode layer 370 may be in the range of, but not limited to, 0.02 to 0.01 *µ*m*.*

The insulating film 380 surrounds outer surfaces of the semiconductor core and the electrode layer 370 described above. In an embodiment, the insulating film 380 may surround an outer surface of at least the active layer 330 and extend in the direction in which the light emitting device 300 extends. The insulating film 380 may protect the above members. For example, the insulating film 380 may surround side surfaces of the above members but may expose both ends of the light emitting device 300 in the longitudinal direction.

In the drawings, the insulating film 380 extends in the longitudinal direction of the light emitting device 300 to cover from side surfaces of the first part 311 of the first semiconductor layer 310 to side surfaces of the electrode layer 370. However, the disclosure is not limited thereto, and the insulating film 380 may also cover outer surfaces of only some semiconductor layers as well as the active layer 330 or may cover only a part of the outer surface of each electrode layer 370 to partially expose the outer surface of the electrode layer 370. In addition, an upper surface of the insulating film 380 may be rounded in cross section in an area adjacent to at least one end of the light emitting device 300.

The insulating film 380 may include a material having insulating properties such as silicon oxide (SiOx), silicon nitride (SiNx), silicon oxynitride (SiOxNy), aluminum nitride (AlN), or aluminum oxide (Al2O3). Therefore, the insulating film 380 can prevent an electrical short circuit that may occur when the active layer 330 directly contacts an electrode through which an electrical signal is transmitted to the light emitting device 300. In addition, the insulating film 380 can prevent a reduction in luminous efficiency by protecting the outer surface of the light emitting device 300 including the active layer 330.

In addition, in some embodiments, an outer surface of the insulating film 380 may be treated. When the display device 10 is manufactured, the light emitting device 300 may be sprayed on electrodes in a state where it is dispersed in a predetermined ink and then may be aligned. Here, the surface of the insulating film 380 may be hydrophobic or hydrophilic-treated so that the light emitting device 300 remains separate from other adjacent light emitting devices 300 in the ink without agglomerating with them.

The insulating film 380 may protect the semiconductor core of the light emitting device 300 including at least the active layer 330. As described above, the insulating film 380 may be partially etched to have a reduced thickness during the manufacturing process of the light emitting device 300 and the manufacturing process of the display device 10. When the insulating film 380 has a thin thickness, the insulating film 380 may be etched away during the manufacturing process, or the semiconductor core, in particular, the active layer 330 may be damaged. To prevent this, the insulating film 380 of the light emitting device 300 according to the embodiment may have more than a certain thickness. In an embodiment, the thickness of the insulating film 380 may be in the range of, but not limited to, 10 nm to 1.0 *µ*m*.* The thickness of the insulating film 380 may preferably be about 40 nm.

A length of the light emitting device 300 may be in the range of 1 to 10 *µ*m or 2 to 6 *µ*m and may preferably be in the range of 3 to 5 *µ*m*.* In addition, a diameter of the light emitting device 300 may be in the range of 300 to 700 nm, and an aspect ratio of the light emitting device 300 may be 1.2 to 100. However, the disclosure is not limited thereto, and a plurality of light emitting devices 300 included in the display device 10 may also have different diameters according to a difference in composition of the active layer 330. The diameter of the light emitting device 300 may preferably be about 600 nm.

As described above, the first semiconductor layer 310 may include the first part 311 and the second part 315 having a greater diameter than the first part 311, and the insulating film 380 may be disposed only on an outer surface of the first part 311. Accordingly, an outer surface of the second part 315 may be exposed and may contact the contact electrode 261 or 262 of the display device 10. The first part 311 and the second part 315 of the first semiconductor layer 310 will now be described in detail with further reference to other drawings.

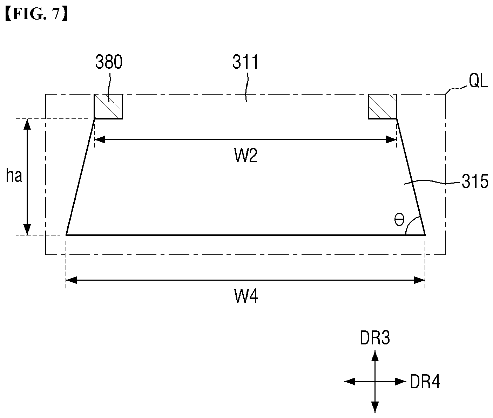

FIG. 7 is an enlarged view of a part QL of FIG. 6.

Referring to FIGS. 5 through 7, the first part 311 of the first semiconductor layer 310 may extend in the same direction as the direction in which the light emitting device 300 extends. The first part 311 extending in the direction may have a flat outer surface in cross section. In some embodiments, the first part 311 may be shaped like a cylinder or a rod. However, the disclosure is not limited thereto. The insulating film 380 to be described later may be disposed on the outer surface of the first part 311 so that the first part 311 does not contact the contact electrode 261 or 262 of the display device 10.

The second part 315 of the first semiconductor layer 310 may be connected to a surface of the first part 311. The second part 315 may be disposed in a direction opposite to the active layer 330 disposed on the first semiconductor layer 310, so that an upper surface of the second part 315 is connected to the first part 311. Unlike the first part 311, the second part 315 of the first semiconductor layer 310 may have lower and side surfaces exposed. As described above, the insulating film 380 of the light emitting device 300 may surround the side surfaces of the first part 311 of the first semiconductor layer 310 as well as the active layer 330 but may not be disposed on the side surfaces of the second part 315. Since the first semiconductor layer 310 further includes the second part 315, the light emitting device 300 may include an exposed area in which the insulating film 380 is not disposed. Accordingly, the light emitting device 300 may contact a contact electrode of the display device 10, for example, the second contact electrode 262 over a large area. The light emitting device 300 may be structured as described above as a result of forming the second part 315 at the same time as or after the process of forming the insulating film 380. This will be described later.

According to an embodiment, in the first semiconductor layer 310 of the light emitting device 300, the diameter of the second part 315 may be greater than the diameter of the first part 311, and the second part 315 may have an inclined outer surface. In the semiconductor core of the light emitting device 300, a plurality of semiconductor layers 310 and 320 and the active layer 330 may be stacked in a third direction DR3, and the first part 311 and the second part 315 of the first semiconductor layer 310 may have different diameters measured in a fourth direction DR4 perpendicular to the third direction DR3. In addition, both ends of the light emitting device 300 may have different diameters measured in the fourth direction DR4.

The first part 311 of the first semiconductor layer 310 may have a first diameter W1 measured in the fourth direction DR4, and the upper surface of the second part 315 may have a second diameter W2 measured in the fourth direction DR4. In addition, an end of the light emitting device 300 at which the electrode layer 370 or the second semiconductor layer 320 is located may have a third diameter W3 measured in the fourth direction DR4, and the other end of the light emitting device 300 at which the second part 315 of the first semiconductor layer 310 is located may have a fourth diameter W4 measured in the fourth direction DR4.

According to an embodiment, the first diameter W1 of the first part 311 of the first semiconductor layer 310 may be smaller than the second diameter W2 of the upper surface of the second part 315. In the first semiconductor layer 310, since the first part 311 and the upper surface of the second part 315 connected to the first part 311 have different diameters, a step may be formed in a part where they are connected. In an embodiment, the second diameter W2 of the upper surface of the second part 315 of the first semiconductor layer 310 may be equal to the sum of the first diameter W1 of the first part 311 and the thickness of the insulating film 380.

As illustrated in FIG. 7, the insulating film 380 may be formed on the outer surface of the first part 311 of the first semiconductor layer 310, and a lower surface of the insulating film 380 may contact an area where the first part 311 and the second part 315 are connected. Accordingly, a step may be formed between the first part 311 and the second part 315 of the first semiconductor layer 310 of the light emitting device 300 but may not be formed between the outer surface of the light emitting device 300, that is, the outer surface of the insulating film 380 and the outer surface of the second part 315. This structure may be obtained because the insulating film 380 and the second part 315 of the first semiconductor layer 310 are formed in the same process during the manufacturing process of the light emitting device 300 as described above. This will be described in more detail later with reference to other drawings.

In addition, according to an embodiment, the second diameter W2 of the upper surface of the second part 315 of the first semiconductor layer 310 may be smaller than the fourth diameter W4 of the lower surface, and the second part 315 may have inclined side surfaces. In the second part 315 of the first semiconductor layer 310, the fourth diameter W4 of the lower surface may be greater than the second diameter W2 of the upper surface to secure a large contact area between the light emitting device 300 and the contact electrode 261 or 262. Accordingly, the second part 315 of the first semiconductor layer 310 may have inclined side surfaces in cross section. Since the side and lower surfaces of the second part 315 are exposed without the insulating film 380 disposed thereon, the second part 315 may contact the contact electrode 261 or 262 of the display device 10 at the side and lower surfaces.

The diameters of an end and the other end of the light emitting device 300 may be adjusted according to contact areas with the contact electrodes 261 and 262 required for the light emitting device 300 to have high luminous efficiency. For example, the fourth diameter W4 of the lower surface of the second part 315 may be 1.25 to 1.8 times the first diameter W1 of the first part 311 of the first semiconductor layer 310. In an embodiment, the first diameter W1 of the first part 311 of the first semiconductor layer 310 may be in the range of 500 to 600 nm, and the fourth diameter W4 of the lower surface of the second part 315 may be in the range of 750 to 900 nm. Accordingly, an included angle θ formed by the lower and side surfaces of the second part 315 may be 65 to 80 degrees, preferably, about 70 degrees.

In addition, a height ha of the second part 315 of the first semiconductor layer 310 may be adjusted by the fourth diameter W4 and the included angle θ between the lower and side surfaces of the second part 315. In some embodiments, the height ha of the second part 315 may be about 10 % of a length h of the light emitting device 300. For example, when the length h of the light emitting device 300 is about 4 *µ*m, the height ha of the second part 315 may be about 400 nm. However, the disclosure is not limited thereto. The included angle θbetween the fourth diameter W4 of the lower surface of the second part 315 and each side surface of the second part 315 and the height ha of the second part 315 may be changed by varying the manufacturing process of the light emitting device 300 according to the contact area with the contact electrode 261 or 262.

Since the first semiconductor layer 310 of the light emitting device 300 has a greater diameter, the fourth diameter W4 of the other end of the light emitting device 300 according to the embodiment may be greater than the third diameter W3 of an end of the light emitting device 300. An end and the other end of the light emitting device 300 may have different diameters, and the second part 315 of the first semiconductor layer 310 on which the insulating film 380 is not disposed may contact a contact electrode 260 of the display device 10 over a large area.

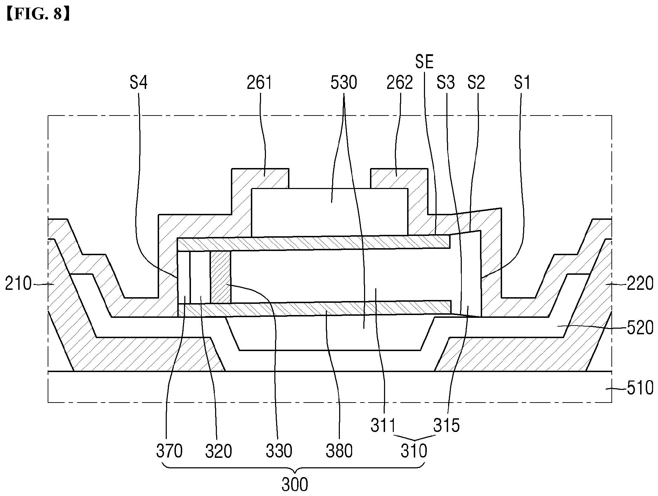

FIG. 8 is an enlarged view of a part QA of FIG. 4.

FIG. 8 is an enlarged cross-sectional view of a light emitting device 300 disposed between the first electrode 210 and the second electrode 220 in the display device 10. Referring to FIG. 8, the light emitting device 300 may be disposed on the second insulating layer 520 between the first electrode 210 and the second electrode 220. The light emitting device 300 may include one end at which the second part 315 of the first semiconductor layer 310 is located and the other end at which the electrode layer 370 or the second semiconductor layer 320 is located. The one end may contact the second contact electrode 262, and the other end may contact the first contact electrode 261. The first contact electrode 261 and the second contact electrode 262 may contact the insulating film 380, the electrode layer 370, and the first semiconductor layer 310 of the light emitting device 300.

The light emitting device 300 may include one side surface which is a lower surface in cross section and the other side surface which is an upper surface among the outer surface of the insulating film 380. The one side surface may contact the second insulating layer 520 and the third insulating layer 530 disposed under the light emitting device 300, and the other side surface may contact the third insulating layer 530 and the contact electrodes 260 disposed on the light emitting device 300.

The one side surface which is the lower surface of the light emitting device 300 may contact the second insulating layer 520 and may contact the third insulating layer 530 in the space formed by partial depression of the second insulating layer 520 and filled with the third insulating layer 530. The one side surface which is the lower surface of the light emitting device 300 in cross section may not be etched during the manufacturing process of the display device 10. Accordingly, a surface in contact with the second insulating layer 520 and the third insulating layer 530 may form a flat surface.

The other side surface which is the upper surface of the light emitting device 300 in cross section may contact the contact electrodes 260 and the third insulating layer 530. Although the insulating film 380 on the other side surface of the light emitting device 300 forms a flat surface in the drawing, the disclosure is not limited thereto. In some embodiments, the insulating film 380 of the light emitting device 300 may be partially etched in an etching process performed before a process of forming the contact electrodes 260.

The display device 10 may include a plurality of contact surfaces at which the light emitting device 300 contacts the contact electrodes 261 and 262 or the second insulating layer 520. For example, the contact surfaces may include a first contact surface S1 at which the second contact electrode 262 contacts the lower surface of the second part 315 of the first semiconductor layer 310, a second contact surface S2 at which the second contact electrode 262 contacts a side surface of the second part 315, a third contact surface S3 at which the second insulating layer 520 contacts a side surface of the second part 315, and a fourth contact surface S4 at which the first contact electrode 261 contacts an upper surface of the electrode layer 370.

The contact surfaces of the light emitting device 300 with the contact electrodes 261 and 262 may include surfaces that are substantially perpendicular to the upper surface of the substrate or the first insulating layer 510 and surfaces that are not. For example, the first contact surface S1 and the fourth contact surface S4 may be formed to be substantially perpendicular to the upper surface of the first insulating layer 510, but the second contact surface S2 may be formed not to be perpendicular to the upper surface of the first insulating layer 510. Since the second part 315 of the light emitting device 300 has the inclined side surfaces, its contact surfaces with the contact electrodes 261 and 262 may also be inclined. However, the disclosure is not limited thereto.

In addition, contact surfaces of the second contact electrode 262 with the first semiconductor layer 310 of the light emitting device 300 may not be parallel to each other. The second contact electrode 262 and the first semiconductor layer 310 may form the first contact surface S1 and the second contact surface S2. The first contact surface S1 is a surface formed by the lower surface of the second part 315 of the first semiconductor layer 310, and the second contact surface S2 is a surface formed by a side surface of the second part 315. In the light emitting device 300 according to the embodiment, since the side surfaces of the second part 315 of the first semiconductor layer 310 are inclined, they are not parallel nor perpendicular to the lower surface. Accordingly, the second contact surface S2 of the second part 315 in contact with the second contact electrode 262 may be inclined with respect to the first contact surface S1.

According to an embodiment, in the display device 10, a contact area between one end surface of the light emitting device 300 and the second contact electrode 262 may be larger than a contact area between the other end surface of the light emitting device 300 and the first contact electrode 261. The one end surface of the light emitting device 300 may be the lower surface of the second part 315 of the first semiconductor layer 310 and may have the fourth diameter W4 illustrated in FIG. 6. The other end surface of the light emitting device 300 may be the upper surface of the electrode layer 370 and may have the first diameter W1, like the first part 311 of the first semiconductor layer 310 as illustrated in FIG. 6. As described above, the fourth diameter W4 may be greater than the first diameter W1, and the first contact surface S1 which is a contact surface between the one end surface of the light emitting device 300 and the second contact electrode 262 may have a larger area than the fourth contact surface S4 which is a contact surface between the other end surface and the first contact electrode 261.

The light emitting device 300 may receive an electrical signal through surfaces at which the semiconductor core contacts the first contact electrode 261 and the second contact electrode 262. That is, an electrical signal may be received through surfaces at which the first semiconductor layer 310 and the electrode layer 370 constituting the semiconductor core contact the contact electrodes 261 and 262, that is, through the first contact surface S1, the second contact surface S2 and the fourth contact surface S4 at both ends of the light emitting device 300. In the display device 10 according to the embodiment, the electrode layer 370 may be disposed at the other end of the light emitting device 300 which contacts the first contact electrode 261 to reduce contact resistance, and the one end of the light emitting device 300 which contacts the second contact electrode 262 may include the second part 315 having a large diameter to increase a contact area, thereby reducing contact resistance. Furthermore, at the one end of the light emitting device 300, a side surface of the second part 315 may contact the second contact electrode 262, and the contact area between the light emitting device 300 and the second contact electrode 262 may increase, and the contact resistance may decrease. Accordingly, electrical characteristics and luminous efficiency of the light emitting device 300 may be improved.

The second contact electrode 262 may contact the insulating film 380 of the light emitting device 300 (see SE in FIG. 8). However, the disclosure is not limited thereto, and the second contact electrode 262 may not contact the insulating film 380 depending on the shape of the third insulating layer 530. This will be described with reference to another embodiment.

The display device 10 may include a larger number of insulating layers. According to an embodiment, the display device 10 may further include a fourth insulating layer 540 disposed to protect the first contact electrode 261.

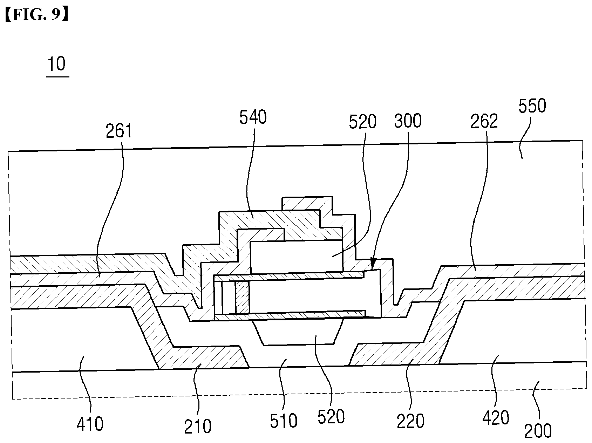

FIG. 9 is a cross-sectional view of a part of a display device according to an embodiment.

Referring to FIG. 9, a display device 10 according to an embodiment may further include a fourth insulating layer 540 disposed on a first contact electrode 261. The display device 10 according to the current embodiment is different from the display device 10 of FIG. 4 in that it further includes the fourth insulating layer 540 and thus at least a part of a second contact electrode 262 is disposed on the fourth insulating layer 540. Therefore, any redundant description will be omitted, and differences will be mainly described below.

The display device 10 of FIG. 9 may include the fourth insulating layer 540 which is disposed on the first contact electrode 261 and electrically insulates the first contact electrode 261 and the second contact electrode 262 from each other. The fourth insulating layer 540 may cover the first contact electrode 261 but may not overlap a part of a light emitting device 300 so that the light emitting device 300 can be connected to the second contact electrode 262. The fourth insulating layer 540 may be disposed on an upper surface of a third insulating layer 530 to partially contact the first contact electrode 261 and the third insulating layer 530. The fourth insulating layer 540 may cover an end of the first contact electrode 261 on the third insulating layer 530. Accordingly, the fourth insulating layer 540 may protect the first contact electrode 261 while electrically insulating the first contact electrode 261 from the second contact electrode 262.

A side surface of the fourth insulating layer 540 in a direction in which the second contact electrode 262 is disposed may be aligned with a side surface of the third insulating layer 530. However, the disclosure is not limited thereto. In some embodiments, the fourth insulating layer 540 may include an inorganic insulating material, like a second insulating layer 520.

The first contact electrode 261 may be disposed between a first electrode 210 and the fourth insulating layer 540, and the second contact electrode 262 may be disposed on the fourth insulating layer 540. The second contact electrode 262 may partially contact the second insulating layer 520, the third insulating layer 530, the fourth insulating layer 540, a second electrode 220, and the light emitting device 300. An end of the second contact electrode 262 in a direction in which the first electrode 210 is disposed may be disposed on the fourth insulating layer 540.

A passivation layer 550 may be disposed on the fourth insulating layer 540 and the second contact electrode 262 to protect them. A redundant description will be omitted below.

A process of manufacturing light emitting devices 300 according to an embodiment will now be described.

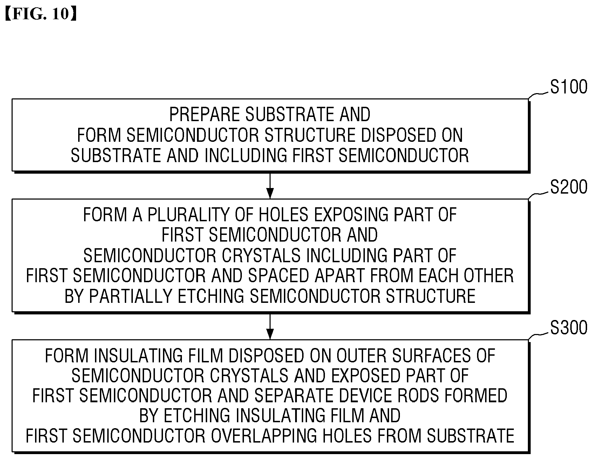

FIG. 10 is a flowchart illustrating a method of manufacturing light emitting devices according to an embodiment.

Referring to FIG. 10, the method of manufacturing light emitting devices 300 according to the embodiment may include preparing a substrate and forming a semiconductor structure disposed on the substrate and including a first semiconductor (operation S100), forming a plurality of holes exposing a part of the first semiconductor and semiconductor crystals including the first semiconductor and spaced apart from each other by partially etching the semiconductor structure (operation S200), and forming an insulating film disposed on outer surfaces of the semiconductor crystals and the exposed part of the first semiconductor and separating device rods formed by etching the insulating film and the first semiconductor overlapping the holes from the substrate (operation S300).

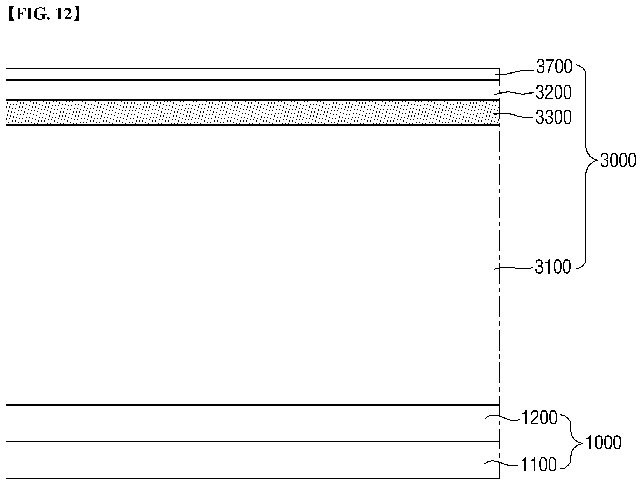

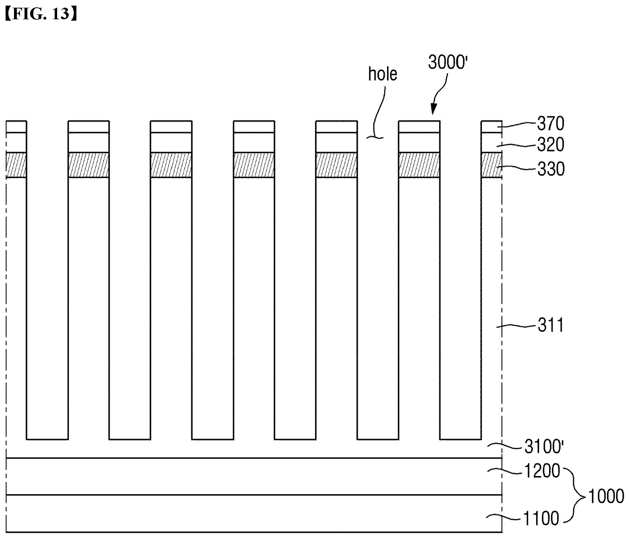

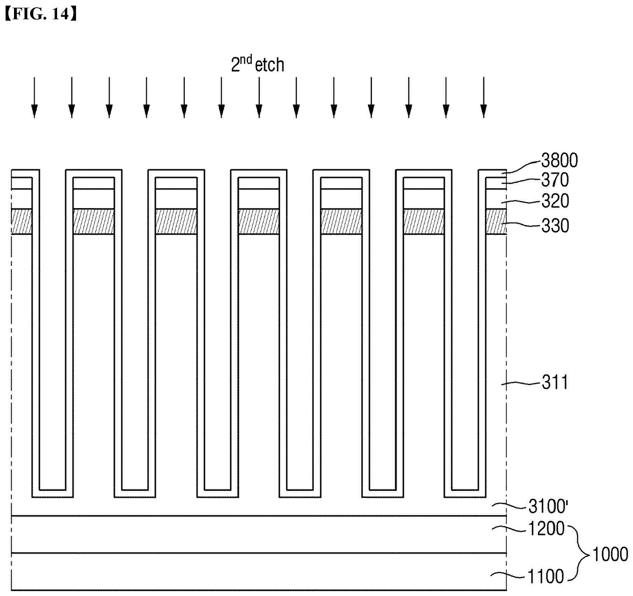

To manufacture light emitting devices 300 according to an embodiment, a semiconductor structure 3000 (see FIG. 12) is formed and partially etched to form semiconductor crystals 3000' (see FIG. 13), each including a first part 311 of a first semiconductor layer 310. Then, an insulating film 3800 (see FIG. 14) surrounding outer surfaces of the semiconductor crystals 3000' is formed, and then the insulating film 3800 and a semiconductor layer under the insulating film 3800 are etched to form an insulating film 380 and a second part 315 of the first semiconductor layer 310. In each of the light emitting devices 300, the second part 315 may be formed to have a greater diameter than the first part 311 in the process of simultaneously forming the insulating film 380 and the second part 315 of the first semiconductor layer 310. The method of manufacturing the light emitting devices 300 will now be described in detail with further reference to other drawings.

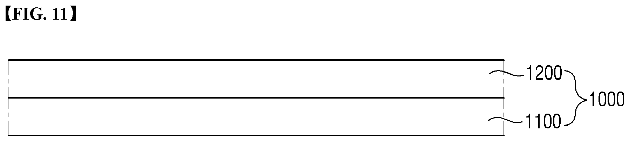

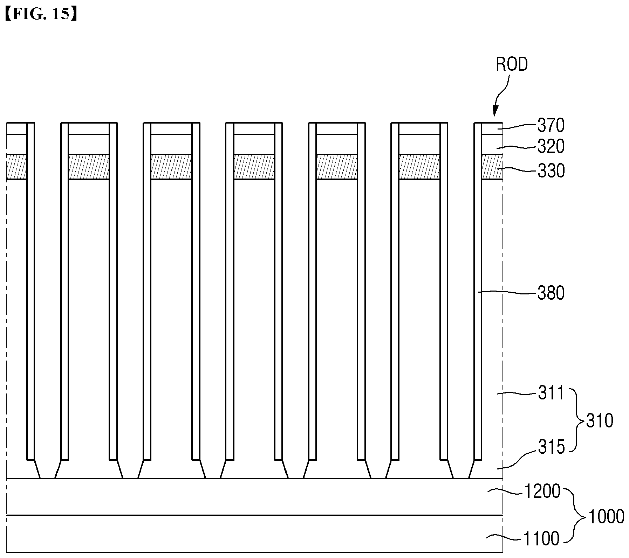

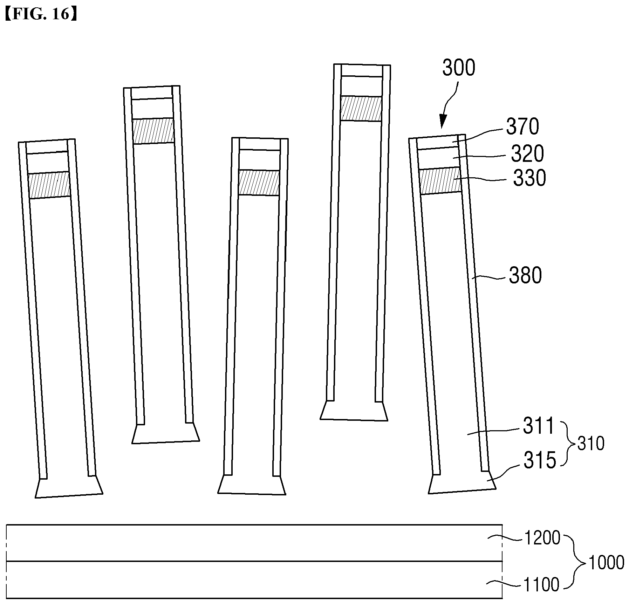

FIGS. 11 through 16 are cross-sectional views illustrating a process of manufacturing light emitting devices according to an embodiment.

First, referring to FIG. 11, a lower substrate 1000 which includes a base substrate 1100 and a buffer material layer 1200 formed on the base substrate 1100 is prepared. The base substrate 1100 may include a sapphire substrate (Al2O3) or a transparent substrate such as glass. However, the disclosure is not limited thereto, and the base substrate 1100 may also be made of a conductive substrate such as GaN, SiC, ZnO, Si, GaP, or GaAs. A case where the base substrate 1100 is a sapphire substrate (Al2O3) will be described below as an example. A thickness of the base substrate 1100 is not particularly limited but may be, for example, in the range of 400 to 1500 *µ*m.

A plurality of semiconductor layers are formed on the base substrate 1100. The semiconductor layers grown by an epitaxial method may be formed by growing seed crystals. Here, the method of forming the semiconductor layers may be electron beam deposition, physical vapor deposition (PVD), chemical vapor deposition (CVD), plasma laser deposition (PLD), dual-type thermal evaporation, sputtering, or metal organic chemical vapor deposition (MOCVD) and may preferably be MOCVD, but the disclosure is not limited thereto.

A precursor material for forming the semiconductor layers is not particularly limited within a range of materials that can be generally selected to form a target material. For example, the precursor material may include a metal precursor including an alkyl group such as a methyl group or an ethyl group. For example, the metal precursor may be, but is not limited to, a compound such as trimethyl gallium (Ga(CH3)3), trimethyl aluminum (Al(CH3)3), or triethyl phosphate (C2H5)3PO4. The method or process conditions for forming the semiconductor layers will not be described below, and the order of the method of manufacturing light emitting devices 300 and the stacked structure of each light emitting device 300 will be described in detail.

The buffer material layer 1200 is formed on the base substrate 1100. Although the buffer material layer 1200 is illustrated as a single layer in the drawings, the disclosure is not limited thereto, and a plurality of layers may also be formed. The buffer material layer 1200 may be disposed to reduce a difference in lattice constant between a first semiconductor 3100 and the base substrate 1100.

For example, the buffer material layer 1200 may include an undoped semiconductor and may include substantially the same material as the first semiconductor 3100 but may be a material not doped with an n type or a p type. In an embodiment, the buffer material layer 1200 may be, but is not limited to, at least any one of undoped InAlGaN, GaN, AlGaN, InGaN, AIN, and InN. In addition, the buffer material layer 1200 may be omitted depending on the base substrate 1100. A case where the buffer material layer 1200 including an undoped semiconductor is formed on the base substrate 1100 will be described as an example.

Next, referring to FIG. 12, a semiconductor structure 3000 is formed on the lower substrate 1000. The semiconductor structure 3000 may include the first semiconductor 3100, an active layer 3300, a second semiconductor 3200, and an electrode material layer 3700. A plurality of material layers included in the semiconductor structure 3000 may be formed by performing a conventional process as described above. A plurality of layers included in the semiconductor structure 3000 may correspond to a plurality of layers of each light emitting device 300 according to an embodiment, respectively. That is, they may include the same materials as a first semiconductor layer 310, an active layer 330, a second semiconductor layer 320, and an electrode layer 370 of each light emitting device 300, respectively.

Next, referring to FIG. 13, a first etching process for partially etching the semiconductor structure 3000 is performed to form holes and semiconductor crystals 3000' spaced apart from each other by the holes. The semiconductor structure 3000 may be etched by a conventional method. For example, the semiconductor structure 3000 may be etched by forming an etch mask layer on the semiconductor structure 3000 and etching the semiconductor structure 3000 along the etch mask layer in a direction perpendicular to the lower substrate 1000.

For example, the process of etching the semiconductor structure 3000 may be dry etching, wet etching, reactive ion etching (RIE), inductively coupled plasma reactive ion etching (ICP-RIE), or the like. Dry etching may be suitable for vertical etching because anisotropic etching is possible. When the above etching methods are used, an etchant may be, but is not limited to, Cl2 or O2.

In some embodiments, the semiconductor structure 3000 may be etched using a combination of dry etching and wet etching. For example, etching in a depth direction may be performed using dry etching, and then wet etching, which is isotropic etching, may be performed so that etched sidewalls lie in a plane perpendicular to a surface.

Each of the semiconductor crystals 3000' may include the electrode layer 370, the second semiconductor layer 320, the active layer 330, and a first part 311 of the first semiconductor layer 310 of a light emitting device 300. Each hole formed by etching the semiconductor structure 3000 may be formed from the electrode layer 370 to a part of the first semiconductor 3100. The first semiconductor 3100' remaining without being etched may form a second part 315 of the first semiconductor layer 310.

Next, an insulating film 3800 surrounding outer surfaces of the semiconductor crystals 3000' is formed.

Referring to FIG. 14, the insulating film 3800 may be formed on side and upper surfaces of the semiconductor crystals 3000' and the first semiconductor 3100 remaining without being etched. The insulating film 3800 is an insulating material that forms an insulating film 390 of each light emitting device 300 and may be formed by coating or immersing an insulating material on the outer surfaces of the semiconductor crystals 3000'. However, the disclosure is not limited thereto. For example, the insulating film 3800 may be formed by atomic layer deposition (ALD).

Next, referring to FIG. 14, a second etching process for partially removing the insulating film 3800 and further etching the first semiconductor 3100 remaining without being etched is performed to form the second parts 315 of the first semiconductor layers 310 and the insulating films 380. Accordingly, device rods ROD, each including a semiconductor core including the first semiconductor layer 310, the active layer 330, etc. and the insulating film 380 surrounding the semiconductor core, may be formed.

The process of partially removing the insulating film 3800 may be achieved by a process such as dry etching, which is anisotropic etching, or etch-back. As illustrated in the drawings, an upper surface of the insulating film 3800 may be removed to expose the electrode layers 370, and the first semiconductor 3100' remaining without being etched may also be partially etched. However, the insulating film 3800 and the first semiconductor 3100' have different etch selectivities and are etched at different rates. While the insulating film 3800 is partially removed to expose upper surfaces of the electrode layers 370, only a part of the first semiconductor 3100' may be etched to form inclined side surfaces. Accordingly, the second part 315 of the first semiconductor layer 310 may be formed in the semiconductor core of each of the device rods ROD.

The device rods ROD may be formed by performing the first etching process for etching the semiconductor structure 3000 and the second etching process for etching the insulating film 3800 and the first semiconductor 3100'. The first etching process and the second etching process may be performed under different processing conditions, and the first semiconductor 3100 formed by the above processes may have a different shape. The first semiconductor 3100 etched by the first etching process may form the first parts 311 of the first semiconductor layers 310, and the first semiconductor 3100' etched by the second etching process may form the second parts 315 of the first semiconductor layers 310.

Although the upper surfaces of the electrode layers 370 are exposed and upper surfaces of the insulating films 380 are flat in the drawings, the disclosure is not limited thereto. In some embodiments, an outer surface of each insulating film 380 may be partially curved in an area surrounding the electrode layer 370. Since not only the upper surface but also side surfaces of the insulating film 3800 are partially removed in the process of partially removing the insulating film 3800, each insulating film 380 surrounding a plurality of layers may be formed such that an end surface thereof is partially etched. In particular, as the upper surface of the insulating film 3800 is removed, the outer surface of the insulating film 380 adjacent to the electrode layer 370 in each light emitting device 300 may be partially removed.

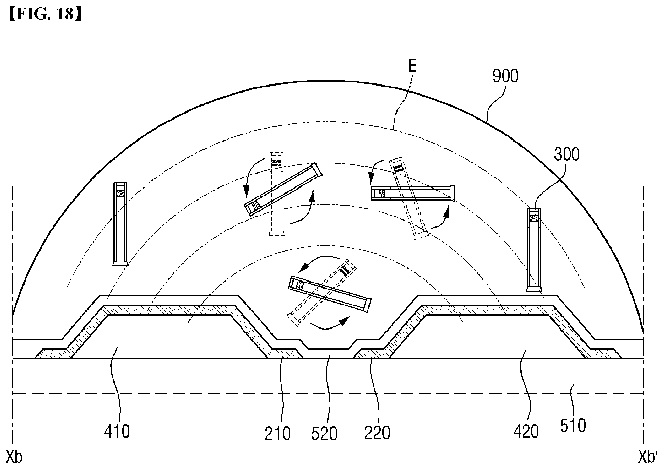

Finally, as illustrated in FIG. 18, the light emitting devices 300 are manufactured by separating the device rods ROD, each having the second part 315 of the first semiconductor layer 310, from the lower substrate 1000.

The light emitting devices 300 according to the embodiment may be manufactured through the process described above. The light emitting devices 300 thus manufactured may be disposed between the first electrode 210 and the second electrode 220, and the third insulating layer 530, the contact electrodes 260, etc. may be placed on the light emitting devices 300 to manufacture the display device 10. A process of manufacturing the display device 10 will now be described with further reference to other drawings.

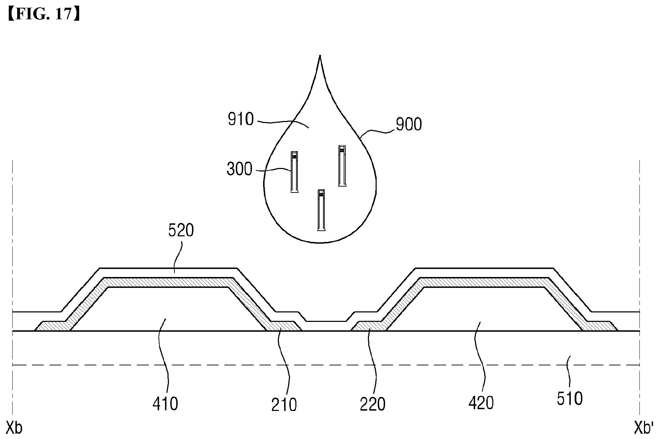

FIGS. 17 through 19 are cross-sectional views illustrating a part of a process of manufacturing a display device according to an embodiment.

First, referring to FIG. 17, a first insulating layer 510, a first inner bank 410 and a second inner bank 420 spaced apart from each other on the first insulating layer 510, a first electrode 210 and a second electrode 220 disposed on the first inner bank 410 and the second inner bank 420, respectively, and a second insulating material layer 520' covering the first electrode 210 and the second electrode 220 are prepared. The second insulating material layer 520' may be partially patterned in a subsequent process to form a second insulating layer 520 of a display device 10. The above members may be formed by patterning a metal, an inorganic material, an organic material, or the like in a conventional mask process.

Next, an ink 900 including light emitting devices 300 is sprayed on the first electrode 210 and the second electrode 220. The ink 900 may include a solvent 910 and the light emitting devices 300 dispersed in the solvent 910. The light emitting devices 300 dispersed in the solvent 910 may be sprayed on the electrodes 210 and 220 and may be aligned between the first electrode 210 and the second electrode 220 by an electrical signal transmitted in a subsequent process.

Next, referring to FIG. 18, an electric field IEL is generated on the ink 900 including the light emitting devices 300 by transmitting an electrical signal to the first electrode 210 and the second electrode 220. The light emitting devices 300 may be subjected to a dielectrophoretic force generated by the electric field IEL and may settle between the first electrode 210 and the second electrode 220 as their orientation direction and position are changed.

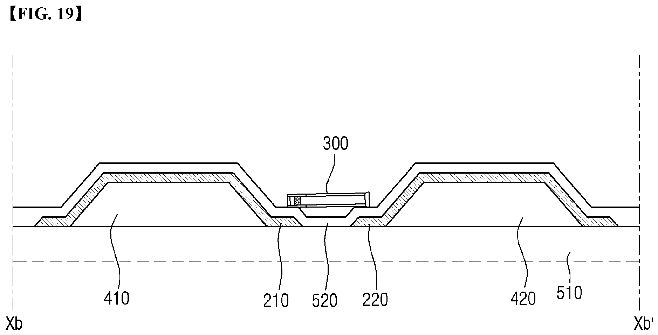

Next, referring to FIG. 19, the solvent 910 of the ink 900 is removed. Accordingly, the light emitting devices 300 may be disposed between the first electrode 210 and the second electrode 220 and may be aligned with a specific orientation direction as they settle between the first electrode 210 and the second electrode 220.

Although not illustrated in the drawings, a third insulating layer 530 is formed on the light emitting devices 300 in a subsequent process, and the second insulating material layer 520' is patterned to form the second insulating layer 520. Then, a first contact electrode 261, a second contact electrode 262, and a passivation layer 550 are formed, thereby manufacturing the display device 10.

The light emitting devices 300 and the display device 10 according to the embodiment may be manufactured as described above. Each of the light emitting devices 300 according to the embodiment may include a first semiconductor layer 310 including a first part 311 and a second part 315 having different diameters, and both ends of each of the light emitting devices 300 may have different diameters. In particular, the second part 315 of the first semiconductor layer 310 may have a greater diameter than an electrode layer 370, and the contact electrodes 261 and 262 and the first semiconductor layer 310 of the display device 10 may contact each other over a large area. Accordingly, the light emitting devices 300 according to the embodiment may have reduced contact resistance with the contact electrodes 261 and 262 and improved luminous efficiency.

Light emitting devices 300 and display devices 10 according to various embodiments will now be described.

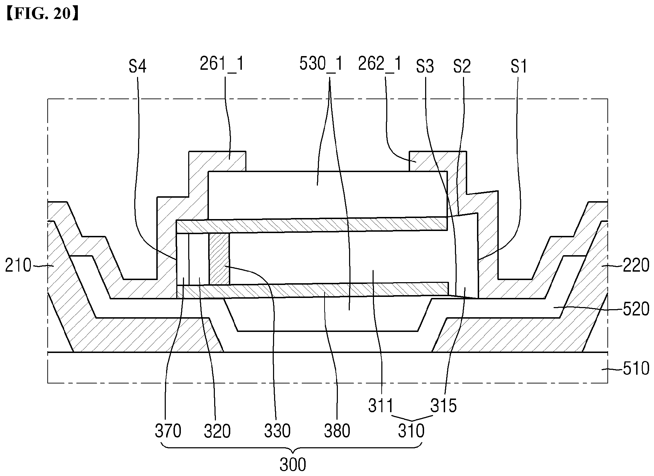

FIG. 20 is a cross-sectional view of a part of a display device according to an embodiment.

Referring to FIG. 20, in a display device 10 according to an embodiment, an insulating film 380_1 of a light emitting device 300_1 may not contact a second contact electrode 262_1. As described above, contact electrodes 261_1 and 262_1 may contact both ends of the light emitting device 300_1. Among them, the second contact electrode 262_1 may contact a first semiconductor layer 310_1 of the light emitting device 300_1, but a part of the insulating film 380_1 which surrounds the first semiconductor layer 310_1 may not contact the second contact electrode 262_1 depending on a width of a third insulating layer 530_3. According to an embodiment, the second contact electrode 262_1 of the display device 10 may not contact the insulating film 380_1 of the light emitting device 300_1 but may contact only a second part 315_1 of the first semiconductor layer 310_1. The current embodiment is different from the embodiment of FIG. 8 in that the second contact electrode 262_1 does not contact the insulating film 380_1. Other members are substantially the same as those described above, and thus a detailed description thereof will be omitted.

As described above, the insulating film 380 may include a partially curved upper surface. In the first etching process for removing the insulating film 3800 during the process of manufacturing the light emitting devices 300, the upper and side surfaces of the insulating film 3800 may be partially etched. Thus, the outer surface of the insulating film 380 may be partially curved.

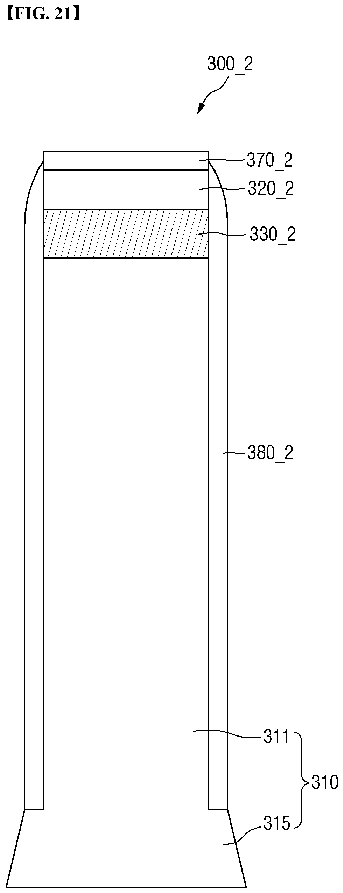

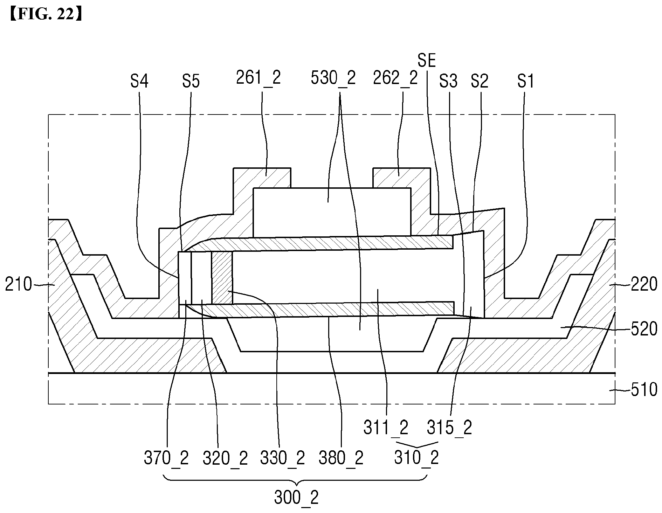

FIG. 21 is a schematic cross-sectional view of a light emitting device according to an embodiment. FIG. 22 is a cross-sectional view of a part of a display device including the light emitting device of FIG. 20.

Referring to FIGS. 21 and 22, a light emitting device 300_2 according to an embodiment may include an area in which an insulating film 380_2 has a partially inclined upper surface or upper cross section and has a partially different thickness. The light emitting device 300_2 of FIG. 21 is different from the light emitting device 300 of FIG. 6 in that an end surface of the insulating film 380_2 is inclined. The arrangement and structure of an electrode layer 370, a first semiconductor layer 310, an active layer 330 and a second semiconductor layer 320 are the same as those of FIG. 6, and thus a redundant description thereof will be omitted, and differences will be mainly described below.

According to an embodiment, the insulating film 380_2 may be disposed such that a part of a semiconductor core, for example, side surfaces of the electrode layer 370_2 are exposed, and an end surface in a part where the electrode layer 370_2 is exposed among the upper surface of the insulating film 380_2 may be partially inclined. Of an outer surface of the electrode layer 370_2, an exposed surface on which the insulating film 380_2 is not disposed may be exposed in a process of etching an insulating film 3800 during a process of manufacturing the light emitting device 300_2. In the case of the light emitting device 300 of FIG. 6, only the upper surface of the electrode layer 370 is exposed in the process of etching the insulating film 3800. On the other hand, in the light emitting device 300_2 of FIG. 21, side surfaces of the electrode layer 370_2 may also be partially exposed together with an upper surface of the electrode layer 370_2. As illustrated in the drawings, the side surfaces of the electrode layer 370_2 may not be completely exposed but may be partially exposed. Therefore, a part of the electrode layer 370_2 may contact the insulating film 380_2.

Since the insulating film 380_2 of the light emitting device 300_2 has a partially curved outer surface and the outer surface of the electrode layer 370_2 is partially exposed, a first contact electrode 261_2 of a display device 10 may also contact a part of a side surface of the electrode layer 370_2. As illustrated in FIG. 22, the first contact electrode 261_2 may contact a part of a side surface of the electrode layer 370_2 of the light emitting device 300_2 to form a fifth contact surface S5. Unlike in the embodiment of FIG. 7, the first contact electrode 261 may contact the upper and side surfaces of the electrode layer 370_2 in addition to the insulating film 380_2 of the light emitting device 300_2, and its contact surface with the insulating film 380_2 may be partially inclined along the curved outer surface of the insulating film 380_2.

As described above, the insulating film 380 of the light emitting device 300 may be partially etched to have a reduced thickness during the process of manufacturing the display device 10. In this case, in the light emitting device 300 included in the display device 10, the thickness of the insulating film 380 may vary according to position, and the diameter of the light emitting device 300 may also vary.

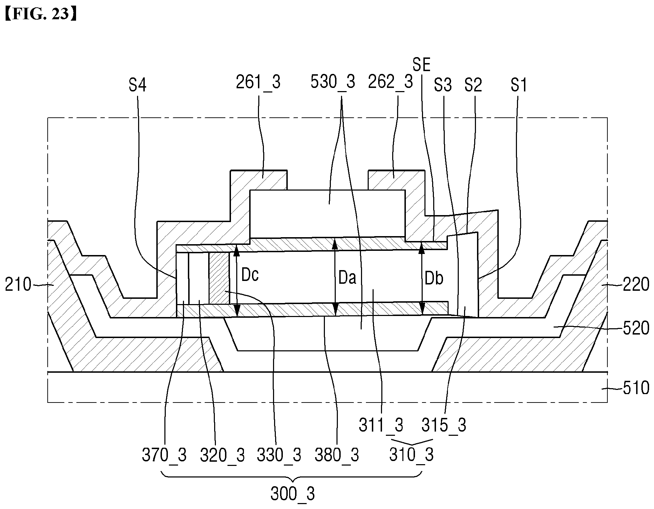

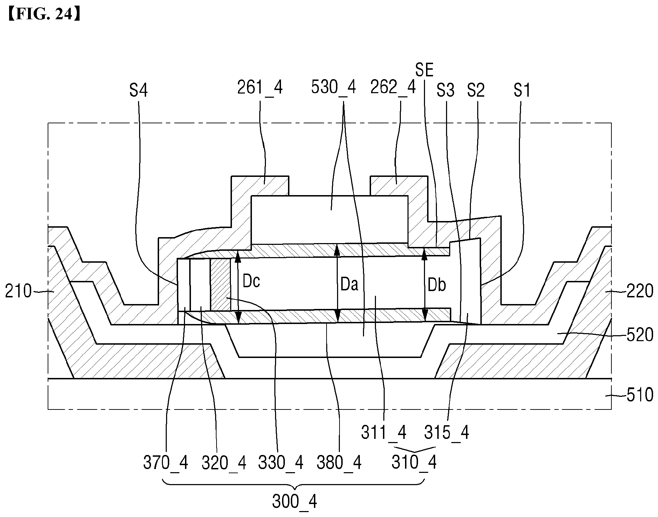

FIGS. 23 and 24 are cross-sectional views of a part of display devices including light emitting devices according to embodiments.

FIG. 23 illustrates that an insulating film 380_3 of a light emitting device 300_3 is partially etched in the display device 10 including the light emitting device 300 of FIG. 6. FIG. 24 illustrates that an insulating film 380_4 of a light emitting device 300_4 is partially etched in the display device 10 including the light emitting device 300_2 of FIG. 21.

Referring to FIG. 23, the insulating film 380_3 that does not contact a third insulating layer 530 may be partially etched in a process of the third insulating layer 530 during a process of manufacturing a display device 10. An outer surface of the light emitting device 300_3 may include one side surface which is a lower surface in cross section and the other side surface which is an upper surface. The one side surface may contact a second insulating layer 520 and the third insulating layer 530 disposed under the light emitting device 300_3. Therefore, the insulating film 380_3 located on the lower surface of the light emitting device 300_3 may not be etched during the process of manufacturing the display device 10_3.

On the other hand, the other side surface of the light emitting device 300_3 which is the upper surface in cross section may be partially etched in an etching process performed before a process of forming contact electrodes 261 and 262. On the other side surface, the insulating film 380_3 may be etched in an area in contact with the contact electrodes 261 and 262, except for a part in contact with the third insulating layer 530. Accordingly, in the display device 10_3, the insulating film 380_3 of the light emitting device 300_3 may have a different thickness according to position.

The insulating film 380_3 may be thinner on a surface in contact with a first contact electrode 261 and a surface in contact with a second contact electrode 262 than on a surface in contact with the second insulating layer 520. On the other hand, since a part of the insulating film 380_3 which contacts the third insulating layer 530 is not etched during the manufacturing process, the insulating film 380_3 may be thicker on a surface in contact with the third insulating layer 530 than on the surface in contact with the first contact electrode 261 and the surface in contact with the second contact electrode 262.

Accordingly, the light emitting device 300_3 may have a different diameter according to position. For example, in the light emitting device 300_3, a first diameter Da measured in an area in contact with the third insulating layer 530 may be greater than a second diameter Db of an area in contact with the second contact electrode 262 and a third diameter Dc of an area in contact with the first contact electrode 261. As described above, the insulating film 380_3 of the light emitting device 300_3 has more than a certain thickness to protect an active layer 330_3 and surrounds at least the active layer 330_3. Even if partially etched during the manufacturing process of the display device 10_3, the insulating film 380_3 may have a minimum required thickness to protect the active layer 330_3. In an embodiment, the insulating film 380_3 of the light emitting device 300_3 disposed in the display device 10_3 may have a thickness of about 10 to 20 nm. The insulating film 380_3 in the above range may prevent the active layer 330_3 from contacting other members, thereby preventing an electrical short circuit of the light emitting device 300_3.

In the embodiment of FIG. 24, the insulating film 380_4 may be partially etched during a process of manufacturing a display device 10_4 including the light emitting device 300_2 of FIG. 21. This is the same as described above with reference to FIGS. 22 and 23, and thus a detailed description thereof will be omitted.

According to some embodiments, the electrode stem parts 210S and 220S extending in the first direction DR1 may be omitted from the first electrode 210 and the second electrode 220.

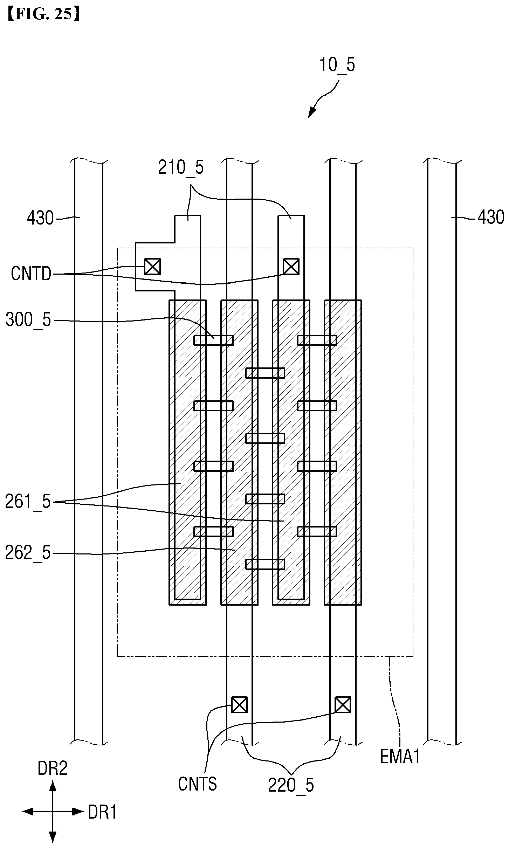

FIG. 25 is a plan view of a subpixel of a display device according to an embodiment.

Referring to FIG. 25, in a display device 10_5, first electrodes 210_5 and second electrodes 220_5 may extend in a direction, that is, the second direction DR2. The first electrodes 210_5 and the second electrodes 220_5 may not include electrode stem parts 210S and 220S extending in the first direction DR1. The display device 10_5 of FIG. 25 is different from the display device 10 of FIG. 3 in that it does not include the electrode stem parts 210S and 220S and includes one more second electrode 220_5. A cross section taken along lines Xa-Xa', Xb-Xb' and Xc-Xc' of FIG. 25 may be substantially the same as FIG. 4. Any redundant description will be omitted, and differences will be mainly described below.

As illustrated in FIG. 25, a plurality of first electrodes 210_5 and a plurality of second electrodes 220_5 may extend in the second direction DR2 in each subpixel PXn. Outer banks 430 may also extend in the second direction DR2. The second electrodes 220_5 and the outer banks 430 may also extend to other subpixels PXn neighboring in the second direction DR2. Accordingly, the subpixels PXn neighboring in the second direction DR2 may receive the same electrical signal from the second electrodes 220 5.

Unlike in the display device 10 of FIG. 3, in the display device 10_5 of FIG. 25, a second electrode contact hole CNTS may be disposed in each of the second electrodes 220_5. Each of the second electrodes 220 may be electrically connected to a power electrode 162 of a circuit device layer PAL through the second electrode contact hole CNTS located in each subpixel PXn. Although the second electrode contact hole CNTS is formed in each of the two second electrodes 220_5 in the drawing, the disclosure is not limited thereto.

On the other hand, the first electrodes 210_5 may extend in the second direction DR2 but may end at the boundary of each subpixel PXn. The subpixels PXn neighboring in the second direction DR2 may each include the first electrodes 210_5 spaced apart from each other and may receive different electrical signals through first electrode contact holes CNTD. This shape of the first electrodes 210_5 may be formed by forming the first electrodes 210_5 extending in the second direction DR2 and then cutting the first electrodes 210_5 at the boundary between neighboring subpixels PXn during a process of manufacturing the display device 10. In the embodiment of FIG. 25, light emitting devices 300 between one first electrode 210_5 and one second electrode 220_5 may be connected in parallel to light emitting devices 300 between another first electrode 210_5 and another second electrode 220_5.

In the display device 10_5 of FIG. 25, some of the electrodes 210_5 and 220_5 may be floating electrodes not electrically connected to the circuit device layer PAL through the electrode contact holes CNTD and CNTS. For example, only outer electrodes among the electrodes 210_5 and 220_5 may receive an electrical signal through the electrode contact holes CNTD and CNTS, and electrodes 210_5 and 220_5 disposed between them may not directly receive an electrical signal. In this case, some of the second electrodes 220_5, for example, the second electrode 220_5 disposed between different first electrodes 210_5 may extend in the second direction DR2 but, like the first electrodes 210_5, may end at the boundary of each siubpixel PXn so as not to lie in another subpixel PXn. When some of the electrodes 210_5 and 220_5 are floating electrodes, the light emitting devices 300 disposed between them may be partially connected in series in addition to the parallel connection. The outer banks 430 may be disposed at the boundaries between the subpixels PXn neighboring each other in the first direction DR1 to extend in the second direction DR2. Although not illustrated in the drawing, the outer banks 430 may also be disposed at the boundaries between the subpixels PXn neighboring each other in the second direction DR2 to extend in the first direction DR1. The outer banks 430 are the same as those described above with reference to FIG. 3. In addition, first contact electrodes 261_5 and second contact electrodes 262_5 included in the display device 10_5 of FIG. 25 are substantially the same as those included in the display device 10 of FIG. 3.

In FIG. 25, two first electrodes 210_5 and two second electrodes 220_5 are disposed and are alternately spaced apart from each other. However, the disclosure is not limited thereto, and some electrodes may be omitted, or more electrodes may be disposed in the display device 10_5.

In the display device 10, the first electrode 210 and the second electrode 220 may not necessarily extend in one direction. The first electrode 210 and the second electrode 220 of the display device 10 are not limited to a particular shape as long as they are spaced apart from each other to provide a space in which the light emitting devices 300 are disposed.

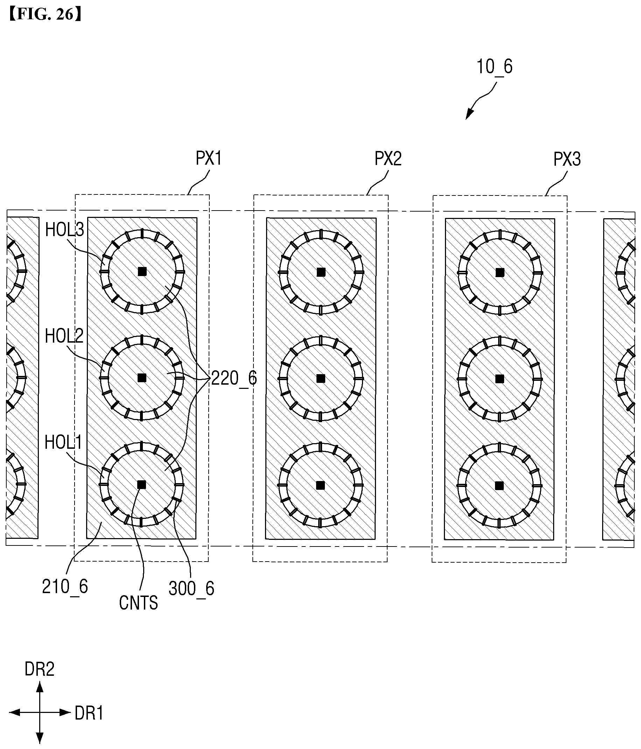

FIG. 26 is a plan view of a pixel of a display device according to an embodiment.

Referring to FIG. 26, a first electrode 210_6 and a second electrode 220_6 of a display device 10_6 according to an embodiment may be at least partially curved, and a curved area of the first electrode 210_6 and a curved area of the second electrode 220_6 may be spaced apart to face each other. The display device 10_6 of FIG. 26 is different from the display device 10 of FIG. 2 in the shape of each of the first electrode 210_6 and the second electrode 220_6. Therefore, any redundant description will be omitted, and differences will be mainly described below.

The first electrode 210_6 of the display device 10_6 of FIG. 26 may include a plurality of holes HOL. For example, as illustrated in the drawing, the first electrode 210_6 may include a first hole HOL1, a second hole HOL2, and a third hole HOL3 arranged along the second direction DR2. However, the disclosure is not limited thereto, and the first electrode 210_6 may include a larger or smaller number of holes HOL or may include only one hole HOL. A case where the first electrode 210_6 includes the first hole HOL1, the second hole HOL2, and the third hole HOL3 will be described below as an example.

In an embodiment, each of the first hole HOL1, the second hole HOL2, and the third hole HOL3 may have a circular planar shape. Accordingly, the first electrode 210_6 may include a curved area formed by each of the holes HOL and may face the second electrode 220_6 in the curved area. However, this is merely an example, and the disclosure is not limited thereto. Each of the first hole HOL1, the second hole HOL2, and the third hole HOL3 is not limited to a particular shape as long as it can provide a space in which the second electrode 220_6 is disposed as will be described later and may have various planar shapes such as an elliptical shape and a quadrangular or more polygonal shape.

The second electrode 220_6 may be provided in plural numbers in each subpixel PXn. For example, three second electrodes 220_6 may be disposed in each subpixel PXn to correspond to the first through third holes HOL1 through HOL3 of the first electrode 210_6. The second electrodes 220_6 may be located in the first through third holes HOL1 through HOL3, respectively, and may be surrounded by the first electrode 210_6.

In an embodiment, the holes HOL of the first electrode 210_6 may have curved outer surfaces, and the second electrodes 220_6 disposed in the holes HOL of the first electrode 210_6 may have curved outer surfaces and may be spaced apart from the first electrode 210_6 to face the first electrode 210_6. As illustrated in FIG. 26, the first electrode 210_6 may include the holes HOL having a circular shape in plan view, and the second electrodes 220_6 may have a circular shape in plan view. The curved surfaces of the areas in which the holes HOL of the first electrode 210_6 are formed may be spaced apart from the curved outer surfaces of the second electrodes 220_6 to face them. For example, the first electrode 210_6 may surround the outer surfaces of the second electrodes 220 6.

As described above, light emitting devices 300 may be disposed between the first electrode 210_6 and the second electrodes 220_6. The display device 10_6 according to the current embodiment may include the second electrodes 220_6 having a circular shape and the first electrode 210_6 surrounding the second electrodes 220_6, and the light emitting devices 300 may be arranged along the curved outer surfaces of the second electrodes 220_6. Since the light emitting devices 300 extend in one direction as described above, the light emitting devices 300 arranged along the curved outer surfaces of the second electrodes 220_6 in each subpixel PXn may be disposed such that their extending directions face different directions. Each subpixel PXn may have various light exit directions according to directions in which the extending directions of the light emitting devices 300 face. In the display device 10_6 according to the current embodiment, since the first electrode 210_6 and the second electrodes 220_6 are disposed to have a curved shape, the light emitting devices 300 disposed between them may face different directions, and lateral visibility of the display device 10_6 may be improved.

In concluding the detailed description, those skilled in the art will appreciate that many variations and modifications can be made to the preferred embodiments without substantially departing from the principles of the invention. Therefore, the disclosed preferred embodiments of the invention are used in a generic and descriptive sense only and not for purposes of limitation.

## Claims

1. A light emitting device comprising:
a first semiconductor layer doped with a first polarity and comprising a first part extending in a first direction and a second part connected to a side of the first part;
a second semiconductor layer doped with a second polarity different from the first polarity;
an active layer disposed between the first semiconductor layer and the second semiconductor layer; and
an insulating film surrounding an outer surface of at least the active layer and extends in the first direction,
wherein a diameter of the second part measured in a second direction perpendicular to the first direction is greater than a diameter of the first part measured in the second direction, and side surfaces of the second part are inclined.

2. The light emitting device of claim 1, wherein the insulating film surrounds an outer surface of the first part of the first semiconductor layer, and
the side surfaces of the second part are exposed without contacting the insulating film.

3. The light emitting device of claim 2, wherein a length of the second part is about 10% of a length of the light emitting device.

4. The light emitting device of claim 2, wherein the second part comprises an upper surface connected to the first part and a lower surface facing the upper surface, and
a diameter of the lower surface of the second part is greater than a diameter of the upper surface.

5. The light emitting device of claim 4, wherein the diameter of the lower surface of the second part of the first semiconductor layer is 1.25 to 1.8 times the diameter of the first part of the first semiconductor layer.

6. The light emitting device of claim 5, wherein the lower surface of the second part has a diameter of 750 to 900 nm.

7. The light emitting device of claim 6, wherein the diameter of the lower surface of the second part is greater than the sum of the diameter of the first part and a thickness of the insulating film.

8. The light emitting device of claim 4, wherein at least a part of the upper surface of the second part contacts the insulating film.

9. The light emitting device of claim 4, wherein an included angle formed by the lower and side surfaces of the second part is in the range of 65 to 80 degrees.

10. The light emitting device of claim 1, further comprising an electrode layer disposed on the second semiconductor layer.

11. The light emitting device of claim 10, wherein a part of side surfaces of the electrode layer is exposed without contacting the insulating film.

12. The light emitting device of claim 11, wherein the insulating film has a curved outer surface so that the thickness of the insulating film is reduced along the one direction.

13. A method of manufacturing light emitting devices, the method comprising:
preparing a substrate and forming a semiconductor structure disposed on the substrate and comprising a first semiconductor;
forming a plurality of holes exposing a part of the first semiconductor and semiconductor crystals comprising a part of the first semiconductor and spaced apart from each other by partially etching the semiconductor structure; and
forming an insulating film disposed on outer surfaces of the semiconductor crystals and the exposed part of the first semiconductor and separating device rods formed by etching the insulating film and the first semiconductor overlapping the holes from the substrate.

14. The method of claim 13, wherein each of the device rods comprises a first semiconductor layer comprising a first part extending in a direction and a second part connected to a side of the first part and having a greater diameter than the first part,
an active layer disposed on the first part of the first semiconductor layer, and
a second semiconductor layer disposed on the active layer.

15. The method of claim 14, wherein each of the semiconductor crystals comprises the first part of the first semiconductor layer, and
In the forming of the device rods, the first semiconductor exposed along the holes is etched to form the second part of the first semiconductor layer, and the insulating film is partially removed to expose upper surfaces of the semiconductor crystals.

16. The method of claim 15, wherein each of the device rods further comprises an electrode layer disposed on the second semiconductor layer.

17. A display device comprising:
a substrate;
a first electrode disposed on the substrate and a second electrode spaced apart from the first electrode; and
at least one light emitting device disposed between the first electrode and the second electrode and electrically connected to the first electrode and the second electrode,
wherein the light emitting device extends in a first direction, and
a diameter of one end measured in a second direction perpendicular to the first direction is smaller than a diameter of the other end measured in the second direction.

18. The display device of claim 17, wherein the light emitting device comprises:
a first semiconductor layer comprising a first part extending in the first direction and a second part connected to a side of the first part;
an active layer disposed on the first semiconductor layer;
a second semiconductor layer disposed on the active layer;
an electrode layer disposed on the second semiconductor layer; and
an insulating film surrounding an outer surface of at least the active layer and extends in the first direction,
wherein a diameter of the second part measured in the second direction is greater than a diameter of the first part measured in the second direction, and side surfaces of the second part are inclined.

19. The display device of claim 18, further comprising a first contact electrode contacting the first electrode and the one end of the light emitting device and
a second contact electrode contacting the second electrode and the other end of the light emitting device.

20. The display device of claim 19, wherein the second contact electrode contacts the second part of the first semiconductor layer and forms a first contact surface in contact with a lower surface of the second part and a second contact surface in contact with a side surface of the second part, and
the first contact electrode contacts an upper surface of the electrode layer to form a third contact surface.

21. The display device of claim 20, wherein the area of the first contact surface is larger than the area of the third contact surface.

22. The display device of claim 20, wherein the first contact surface and the second contact surface are not parallel to each other.

23. The display device of claim 20, wherein the insulating film of the light emitting device partially surrounds side surfaces of the electrode layer, and
the first contact electrode contacts the exposed side surfaces of the electrode layer.

24. The display device of claim 19, wherein each of the first contact electrode and the second contact electrode partially contacts the insulating film of the light emitting device.
